(19) Europäisches Patentamt
European Patent Office
Office européen des brevets

(11) **EP 4 787 005 A2**

(12) **EUROPEAN PATENT APPLICATION**

(43) Date of publication:
**05.08.2026 Bulletin 2026/32**

(21) Application number: **26151089.5**

(22) Date of filing: **09.01.2026**

(51) International Patent Classification (IPC):
*G01R 33/48* (2006.01)    *G01R 33/50* (2006.01)
*G01R 33/56* (2006.01)    *G01R 33/561* (2006.01)
*G01R 33/563* (2006.01)

(52) Cooperative Patent Classification (CPC):
**G01R 33/50; G01R 33/4816; G01R 33/5605; G01R 33/5608; G01R 33/5615; G01R 33/56358**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.01.2025 JP 2025004293**
**27.10.2025 JP 2025181189**

(71) Applicant: **Canon Medical Systems Corporation Tochigi (JP)**

(72) Inventor: **NOMURA, Ei**
**Otawara-shi (JP)**

(74) Representative: **Marks & Clerk LLP**
**15 Fetter Lane**
**London EC4A 1BW (GB)**

(54) **MAGNETIC RESONANCE IMAGING APPARATUS AND INFORMATION PROCESSING APPARATUS**

(57)    An MRI apparatus (1) according to an embodiment includes a setting unit and a scanner. The setting unit is configured to set a pulse sequence including a plurality of sub pulse sequences to acquire a plurality of MR data each corresponding to a different one of a plurality of echo signals emitted from an object after applying a MT pulse and a RF pulse to the object, each of the plurality of sub pulse sequences corresponding to an Ultrashort Echo Time sequence. The scanner is configured to acquire the plurality of MR data based on the pulse sequence set by the setting unit. The MR data corresponding to an initial echo signal after the application of the RF pulse to the object among the plurality of echo signals in at least one of the plurality of sub pulse sequences is used for analyzing both bound water and free water in the object.

FIG. 7

## Description

### FIELD

Embodiments disclosed in the present specification and the drawings are related to a Magnetic Resonance Imaging (MRI) apparatus and an information processing apparatus.

### BACKGROUND

An MRI apparatus is an imaging apparatus configured, together with exciting an atomic nucleus spin in an object placed in a static magnetic field with a Radio Frequency (RF) pulse having a Larmor frequency, to perform a scan for acquiring Magnetic Resonance (MR) data realized by an MR signal occurring from the object in response to the excitation, and to generate an MR image based on the MR data acquired by the scan.

In recent years, an Ultrashort Echo Time (UTE) sequence is used for making it possible to image a subject of measurement having an extremely short transverse relaxation time (a T2 value or a T2* value taking magnetic field non-uniformity into consideration).

For example, a UTE sequence is utilized clinically or in researches, for the purpose of quantitatively evaluating free water or pore water. Further, clinical studies using a UTE Magnetization Transfer (UTE-MT) sequence have advanced for the purpose of measuring or evaluating bound water which has an extremely short transverse relaxation time because of being tightly bound to a biopolymer.

However, free water and bound water in living bodies have conventionally been observed separately from each other. No method has been established for systematically evaluating information about free water and information about bound water or for making a quantitative evaluation when multiple types of bound water are present.

### SUMMARY OF THE INVENTION

One of the problems to be solved by the embodiments disclosed in the present specification and the drawings is to simultaneously acquire and systematically evaluate information about free water and information about bound water in a living body. It should be noted, however, that possible problems to be solved by the embodiments disclosed in the present specification and the drawings are not limited to the problem presented above. It is also possible to regard problems corresponding to the advantageous effects achieved by the configurations described in the following embodiments as other problems.

An MRI apparatus according to an embodiment includes a setting unit and a scanner. The setting unit is configured to set a pulse sequence including a plurality of sub pulse sequences to acquire a plurality of Magnetic Resonance (MR) data each corresponding to a different one of a plurality of echo signals emitted from an object after applying a Magnetization Transfer (MT) pulse and a Radio Frequency (RF) pulse to the object, each of the plurality of sub pulse sequences corresponding to a UTE sequence. The scanner is configured to acquire the plurality of MR data based on the pulse sequence set by the setting unit. The MR data corresponding to an initial echo signal after the application of the RF pulse to the object among the plurality of echo signals in at least one of the plurality of sub pulse sequences is used for analyzing both bound water and free water in the object.

An off-resonance frequency of the MT pulse in a first sub pulse sequence included in the plurality of sub pulse sequences may be different from an off-resonance frequency of the MT pulse in a second sub pulse sequence included in the plurality of sub pulse sequences.

The setting unit may further set the pulse sequence in such a manner that an echo time (TE) corresponding to the initial echo signal after the application of the RF pulse to the object among the plurality of echo signals in a first sub pulse sequence included in the plurality of sub pulse sequences is same as a TE corresponding to an initial echo signal after the application of the RF pulse to the object among the plurality of echo signals in a second sub pulse sequence included in the plurality of sub pulse sequences.

The setting unit may further set the pulse sequence in such a manner that a TE corresponding to second and later echo signals after the application of the RF pulse to the object among the plurality of echo signals in the first sub pulse sequence is different from a TE corresponding to second and later echo signals after the application of the RF pulse to the object among the plurality of echo signals in the second sub pulse sequence.

The scanner may further acquire the plurality of MR data with respect to the object's in vivo tissue that includes the free water and the bound water as components.

The in vivo tissue may be one of: a deep radial cartilage, a calcified cartilage, a meniscus, a ligament, a tendon, a cortical bone, a lung, a cranial nervous system, a central nervous system, and a peripheral nervous system.

The setting unit may further set the pulse sequence in such a manner that the lower the off-resonance frequency is, the larger an echo space is, the echo space being an acquisition interval of each of the plurality of echo signals.

An information processing apparatus according to an embodiment includes an obtainment unit and an analysis unit. The obtainment unit is configured to obtain a plurality of MR data each corresponding to a different one of a plurality of echo signals emitted from an object after applying an MT pulse and an RF pulse to the object, the plurality of MR data being acquired by a pulse sequence including a plurality of sub pulse sequences each corresponding to a UTE sequence The analysis unit is configured to analyze both bound water and free water in the object, based on MR data corresponding to an initial echo signal after the application of the RF pulse to the object among the plurality of echo signals in at least one of the plurality of sub pulse sequences.

The MRI apparatus and the information processing apparatus may further include a classification unit configured to classify the plurality of MR data into a plurality of first MR data each corresponding to a different one of off-resonance frequencies and a plurality of second MR data each corresponding to a different one of TEs.

The MRI apparatus and the information processing apparatus may further include an elastic modulus estimation unit configured to estimate an elastic modulus with respect to each of components of the in vivo tissue, based on at least one of the plurality of first MR data and the plurality of second MR data.

The MRI apparatus and the information processing apparatus may further include a T2* estimation unit configured to estimate a first T2* value based on the plurality of first MR data, a T2* analysis unit configured to estimate a second T2* value based on the plurality of second MR data, and an elastic modulus estimation unit configured to estimate an elastic modulus with respect to each of components of the in vivo tissue, based on the first T2* value and the second T2* value.

The first T2* value and the second T2* value may include T2* values of both of the free water and the bound water.

The MRI apparatus and the information processing apparatus may further include a map generation unit configured to generate an elastic modulus map expressing, with pixel values, the elastic modulus with respect to each of the components of the in vivo tissue.

The MRI apparatus and the information processing apparatus may further include an OSR analysis unit configured to calculate an Off-resonance Saturation Ratio (OSR) with respect to each of the off-resonance frequencies based on the plurality of first MR data, calculate a dominant off-resonance frequency with respect to each of components of the in vivo tissue based on the OSR of each of the off-resonance frequencies, and calculate a component ratio gradient based on the dominant off-resonance frequency with respect to each of the components of the in vivo tissue.

The MRI apparatus and the information processing apparatus may further include an elastic modulus estimation unit configured to estimate an elastic modulus with respect to each of the components of the in vivo tissue, based on the component ratio gradient.

The components of the in vivo tissue may include a component related to loosely bound water and a component related to tightly bound water.

The OSR analysis unit may further isolate and calculate the dominant off-resonance frequency with respect to each of the components of the in vivo tissue, by fitting an exponential function model to a binding model of all the components of the in vivo tissue.

The OSR analysis unit may further calculate the component ratio gradient being a slope of a component ratio with respect to the off-resonance frequencies, based on the dominant off-resonance frequency with respect to each of the components of the in vivo tissue.

The MRI apparatus and the information processing apparatus may further include a map generation unit configured to generate at least one map selected from among: an OSR map expressing, with pixel values, the OSR with respect to each of the off-resonance frequencies; an OSR component map expressing, with pixel values, the dominant off-resonance frequency with respect to each of the components of the in vivo tissue; a component ratio gradient map expressing, with pixel values, the component ratio gradient with respect to each of the components of the in vivo tissue; and an elastic modulus map expressing, with pixel values, the elastic modulus with respect to each of the components of the in vivo tissue.

The MRI apparatus and the information processing apparatus may further include a T2* analysis unit configured to estimate a T2* value based on the plurality of second MR data and a map generation unit configured to generate a T2* map expressing the T2* value with a pixel value.

The MRI apparatus and the information processing apparatus may further include a T2* estimation unit configured to estimate a first T2* value based on the first MR data, a T2* analysis unit configured to estimate a second T2* value based on the second MR data, and a map generation unit configured to generate a T2* map expressing T2* values with pixel values, based on the first T2* value and the second T2* value.

A magnetic resonance imaging apparatus including the information processing apparatus described above.

BRIEF DESCRIPTION OF THE DRAWINGS

Fig. 1 is a block diagram showing an overall configuration example of an MRI apparatus according to an embodiment;

Fig. 2 is a drawing for explaining pore water, loosely bound water, tightly bound water, and structure water in a cortical bone;

Fig. 3 is a Nuclear Magnetic Resonance (NMR) spectrum chart showing a difference in T2 values between free water and bound water in a living body;

Fig. 4 is a drawing for explaining a region where bound water is dominant and a region where free water is dominant;

Fig. 5 is a block diagram showing processing circuitry of an MRI apparatus according to a first embodiment;

Fig. 6 is a flowchart showing an operation example of the MRI apparatus according to the first embodiment;

Fig. 7 is a sequence chart showing a pulse sequence example according to an embodiment;

Fig. 8 is a drawing for explaining improvement of a data acquisition ratio achieved by a pulse sequence example according to an embodiment;

Fig. 9A is a drawing showing a first setting example of imaging conditions for a pulse sequence according to an embodiment;

Fig. 9B is a drawing showing a second setting example of imaging conditions for a pulse sequence according to the embodiment;

Fig. 10 is a drawing for explaining magnetization transfer of pore water, loosely bound water, and tightly bound water;

Fig. 11 is a flowchart showing an operation example in step ST20 of the MRI apparatus according to the first embodiment;

Fig. 12A, Fig. 12B, and Fig. 12C are graphs showing examples of off-resonance frequencies vs OSR characteristics of a cortical bone and rubber, with respect to mutually-different MT pulse intensities;

Fig. 13A is a graph showing a relationship between off-resonance frequencies and OSRs in a specific voxel;

Fig. 13B is a map image expressing the OSRs corresponding to the off-resonance frequencies as pixel values;

Fig. 14A is a graph showing an example in which exponential function models are fitted to off-resonance frequencies vs OSR characteristics with respect to a cortical bone;

Fig. 14B is a graph showing an example in which an exponential function model is fitted to off-resonance frequencies vs OSR characteristics with respect to rubber;

Fig. 14C is a map image expressing, as pixel values, off-resonance frequencies of loosely bound water and tightly bound water;

Fig. 15 is a graph showing a relationship between off-resonance frequencies and OSRs, with respect to two types of phantoms and a cortical bone;

Fig. 16A is a graph showing a relationship between off-resonance frequencies and component ratios with respect to the two types of phantoms and the cortical bone;

Fig. 16B is a graph showing component ratio gradients calculated based on the relationship in Fig. 16A;

Fig. 17 is a flowchart showing an operation example in step ST30 for information processing according to the first embodiment;

Fig. 18 is a graph showing a T2* decay curve exhibited by a UTE sequence;

Fig. 19 is a block diagram showing an overall configuration example of an information processing apparatus according to an embodiment;

Fig. 20 is a block diagram showing processing circuitry of an MRI apparatus according to a second embodiment;

Fig. 21 is a flowchart showing an operation example of the MRI apparatus according to the second embodiment;

Fig. 22 is a block diagram showing processing circuitry of an MRI apparatus according to a modification example of the second embodiment; and

Fig. 23 is a flowchart showing an operation example of the MRI apparatus according to the modification example of the second embodiment.

DETAILED DESCRIPTION

The following will describe an MRI apparatus and an information processing apparatus according to embodiments, with reference to the accompanying drawings. In the drawings, some of the elements that are the same as each other will be referred to by using the same reference characters, and duplicate descriptions thereof will be omitted.

(An overall configuration of an MRI apparatus)

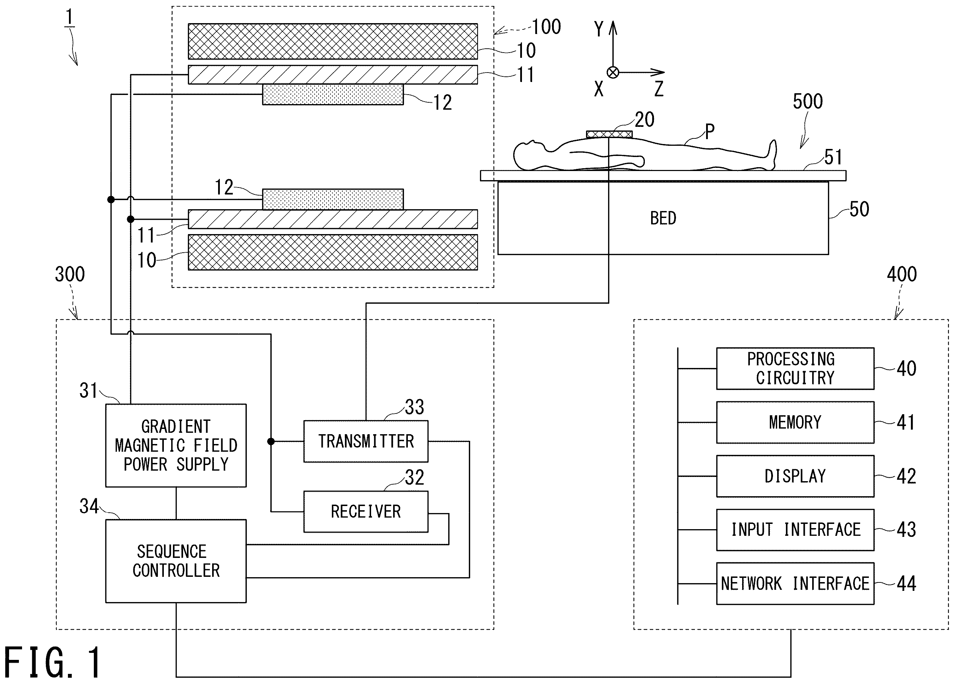

Fig. 1 is a block diagram showing an overall configuration example of an MRI apparatus 1 according to an embodiment. The MRI apparatus 1 includes a gantry apparatus 100, a control cabinet 300, a console 400, and a table 500.

The gantry apparatus 100 includes a static magnetic field magnet 10, a gradient magnetic field coil 11, and a Whole Body (WB) coil 12. These constituent elements are housed in a circular cylindrical casing.

The static magnetic field magnet 10 has a substantially circular cylindrical shape and generates a static magnetic field in a bore the inside of which a patient being an object is carried into. The bore denotes an examination space inside the circular cylinder of the static magnetic field magnet 10. The static magnetic field magnet 10 has a superconductive coil built therein, and the superconductive coil is cooled by liquid helium to an extremely low temperature. The static magnetic field magnet 10 generates a static magnetic field by applying, to the superconductive coil, a current supplied from a static magnetic field power source (not shown) in a magnetic excitation mode. After that, when the static magnetic field magnet 10 has transitioned into a permanent current mode, the static magnetic field power source is separated. Having once transitioned into the permanent current mode, the static magnetic field magnet 10 keeps generating a large static magnetic field for a long period of time, such as one year or longer, for example. The static magnetic field magnet 10 may be configured by using a permanent magnet.

The gradient magnetic field coil 11 has a substantially circular cylindrical shape and is fixed to the inside of the static magnetic field magnet 10 in the radial direction of the circular cylindrical shape. The gradient magnetic field coil 11 generates a gradient magnetic field by receiving a supply of a current from a gradient magnetic field power source 31. The gradient magnetic field coil 11 is formed by combining three coils corresponding to axes orthogonal to one another, namely, an X axis, a Y axis, and a Z axis. By individually receiving the supply of the current from the gradient magnetic field power source 31, the three coils generate the gradient magnetic field of which magnetic field intensities change along the axes, namely, the X axis, the Y axis, and the Z axis.

As shown in Fig. 1, the left-and-right directions of an object P placed on the table 500 will be referred to as X axis directions; the front-and-rear directions (the body thickness directions) will be referred to as Y axis directions; and the head-to-foot directions will be referred to as Z axis directions. The X axis, the Y axis, and the Z axis are orthogonal to one another.

The WB coil 12 is an RF coil that has a substantially circular cylindrical shape and is fixed to the inside of the gradient magnetic field coil 11 so as to surround the object. The WB coil 12 transmits, to the object, an RF pulse transferred thereto from a transmitter 32 and receives an MR signal emitted from the object P in response to excitation of a hydrogen atomic nucleus.

The MRI apparatus 1 may have a local coil 20 in addition to the WB coil 12. The local coil 20 is an RF coil disposed in proximity to the object and receives an MR signal emitted from the object in a position close to the object. The local coil 20 may transmit an RF pulse transmitted from the transmitter 32 to the object. There are various types of local coils 20 corresponding to imaged sites of the object, such as the head, the chest, (e.g., Fig. 1), the spine, a leg, and the whole body.

The control cabinet 300 includes the gradient magnetic field power source 31, the transmitter 32, a receiver 33, and a sequence controller 34. Under control of the sequence controller 34, the gradient magnetic field power source 31 causes the gradient magnetic field coil 11 to generate the gradient magnetic field formed along the axes, namely, the X axis, the Y axis, and the Z axis, by supplying the current thereto.

Based on an instruction from the sequence controller 34, the transmitter 32 generates an RF pulse sequence in a Larmor frequency band as an RF transmission wave and outputs the generated RF transmission wave to the RF coil so as to excite the object P.

The receiver 33 performs an Analog-Digital (AD: Analog-to-Digital) conversion the MR signal received by the RF coil and outputs the converted result to the sequence controller 34. The digitalized MR signal will be referred to as raw data.

Under control of the console 400, the sequence controller 34 executes a scan of the object P, by driving the gradient magnetic field power source 31, the transmitter 32, and the receiver 33. The sequence controller 34 receives the raw data via the receiver 33 and transmits the received raw data to the console 400.

The sequence controller 34 is provided with processing circuitry (not shown). The processing circuitry of the sequence controller 34 is configured, for example, with a processor that executes a predetermined program or hardware such as a Field Programmable Gate Array (FPGA) or an Application Specific Integrated Circuit (ASIC).

The table 500 includes a table main body 50 and a tabletop 51. The table main body 50 is capable of moving the tabletop 51 in up-and-down directions and horizontal directions. The object P placed on the tabletop 51 is moved to a prescribed height and is further moved into the bore.

The console 400 includes processing circuitry 40, a memory 41, a display 42, an input interface 43, and a network interface 44.

The memory 41 is a storage medium including an external storage apparatus such as a Hard Disk Drive (HDD) or an optical disc apparatus, in addition to a Read Only Memory (ROM) and a Random Access Memory (RAM). The memory 41 stores therein various types of information and data and stores therein various types of programs to be executed by the processor included in the processing circuitry 40.

The display 42 is a display device such as a liquid crystal display panel, a plasma display panel, or an organic Electroluminescence (EL) panel. The display 42 may be a Graphical User Interface (GUI) that displays various types of information and data under the control of the processing circuitry 40 and also functions as an input device.

The input interface 43 includes: various types of input devices used by a user such as a medical technologist for inputting various types of information and data; and an input circuitry that processes signals received from the input devices. The input devices may be, for example, a mouse, a keyboard, a trackball, and a touch panel. When any of the input devices is operated, the input circuitry generates an instruction signal corresponding to the operation and outputs the generated instruction signal to the processing circuitry 40.

The network interface 44 communicates with various types of apparatuses connected to a network in a wired or wireless manner, so as to exchange various types of information and data.

For example, the processing circuitry 40 is a circuit including a CPU or a dedicated or generic processor. The processor executes various types of programs that are stored in the memory 41 in advance or directly incorporated in the processing circuitry 40.

By employing these constituent elements, the console 400 controls the entirety of the MRI apparatus 1. More specifically, the processing circuitry 40 receives an instruction related to imaging conditions, through an operation performed by the user via the input interface 43. After that, the processing circuitry 40 causes the sequence controller 34 to execute the scan based on the input imaging conditions. In the present disclosure, a configuration including the gantry apparatus 100, the control cabinet 300, and the table 500 in the MRI apparatus 1, i.e., the configuration for executing the scan on the object, will be referred to as a "scanner". Further, the processing circuitry 40 reconstructs an MR image based on the raw data transmitted thereto from the sequence controller 34. The reconstructed MR image is displayed on the display 42 and saved in the memory 41.

(Free Water and Bound Water)

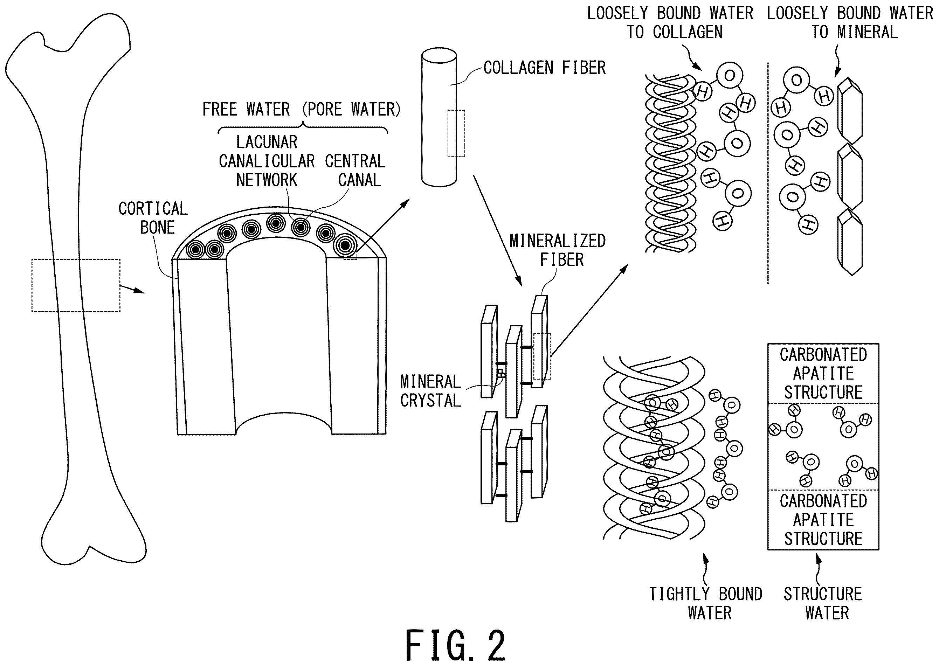

Next, with reference to Fig. 2, regarding a cortical bone, pore water being an example of free water, as well as Loosely Bound Water (LBW), Tightly Bound Water (TBW), and structure water being examples of non-free water will be described. Although the example using the cortical bone will be described below, possible sites in a living body subject to the measurement are not limited to cortical bones, and any site including free water and non-free water may be used.

The cortical bone has central canals through which blood vessels and nerves pass and a lacunar canalicular network for performing substance exchanges and information transmissions between bone cells. Pore water is present in the central canals and the lacunar canalicular network. Further, the cortical bone has collagen fibers having a helical structure. When having been mineralized by a mineral (e.g., a calcium salt), the collagen fibers become mineralized fibers. The loosely bound water is present at an interface between the collagen fibers and mineral crystals and is loosely bound to the collagen or the mineral. The tightly bound water is bound to a triple helix structure of the collagen and forms a water bridge, and is thus present as cleft water in the triple helix structure or as water contributing to an interfacial monolayer. The structure water is present as water that is introduced to the surroundings of a carbonated apatite structure lattice and forms a hydrogen bond between ions inside apatite crystals.

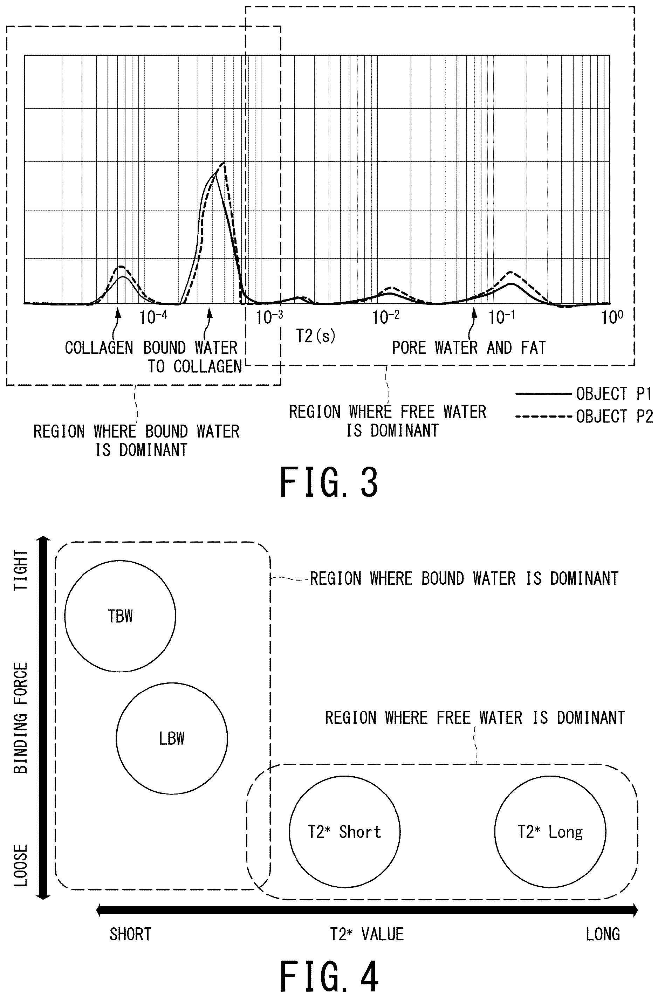

Fig. 3 presents a chart showing an example of a T2 spectrum exhibited by a proton Nuclear Magnetic Resonance (NMR) of a cortical bone. The solid line and the broken line in Fig. 3 indicate that the shapes of the T2 spectrum vary among objects. As shown in Fig. 3, T2 values of the collagen are approximately 60 $\mu$s; T2 values of the bound water in the collagen are approximately 400 $\mu$s; and T2 values of the pore water and fat are approximately 1 ms to 1s.

Further, T2 values of the periosteum are approximately 5 ms to 11 ms; T2 values of a deep layer of an articular cartilage are approximately 5 ms to 10 ms; T2 values of a meniscus are approximately 5 ms to 8 ms; T2 values of a ligament are approximately 4 ms to 10 ms; T2 values of an Achilles tendon are approximately 0.2 ms to 7 ms; T2 values of a cortical bone are approximately 0.4 ms to 0.5 ms; T2 values of dentin are approximately 0.15 ms; T2 values of myelin, which is a primary component of the central nervous system and the peripheral nervous system, are approximately 50 $\mu$s to 1000 $\mu$s; T2 values of enamel are approximately 70 $\mu$s; T2 values of a proton in protein are approximately 10 $\mu$s; T2 values of a proton in a solid such as calcium hydroxyapatite are equal to or smaller than 1 $\mu$s. As listed herein, a dynamic range of the cortical bone subject to the measurement is a prescribed range including a span from a proton in a solid to a proton in a liquid, i.e., the prescribed range including both free water and non-free water, and is generally considered to be wide.

Fig. 4 is a drawing for explaining a region where bound water is dominant and a region where free water is dominant. There is a mutual complementary relationship between tissues in the living body of an object serving as a subject of measurement; however, conventionally, a region where bound water is dominant and a region where free water is dominant are measured separately. Thus, the mutual complementary relationship between the tissues in the living body of the object are not systematically measured. More specifically, no method has been established for systematically evaluating information about free water and information about bound water or for making a quantitative evaluation when multiple types of bound water are present.

To cope with the circumstances described above, the MRI apparatus 1 according to an embodiment makes it possible to simultaneously acquire and systematically evaluate information about free water and information about bound water in a living body. Firstly, by using a single pulse sequence, the MRI apparatus 1 simultaneously acquires MR data reflecting a binding force in a site of the living body subject to the measurement and MR data reflecting T2* values, of which the data has conventionally been acquired separately. Secondly, the MRI apparatus 1 performs analyses for systematically evaluating the information about free water and the information about bound water and for making a quantitative evaluation when multiple types of bound water are present.

**EP 4 787 005 A2**

(First Embodiment)

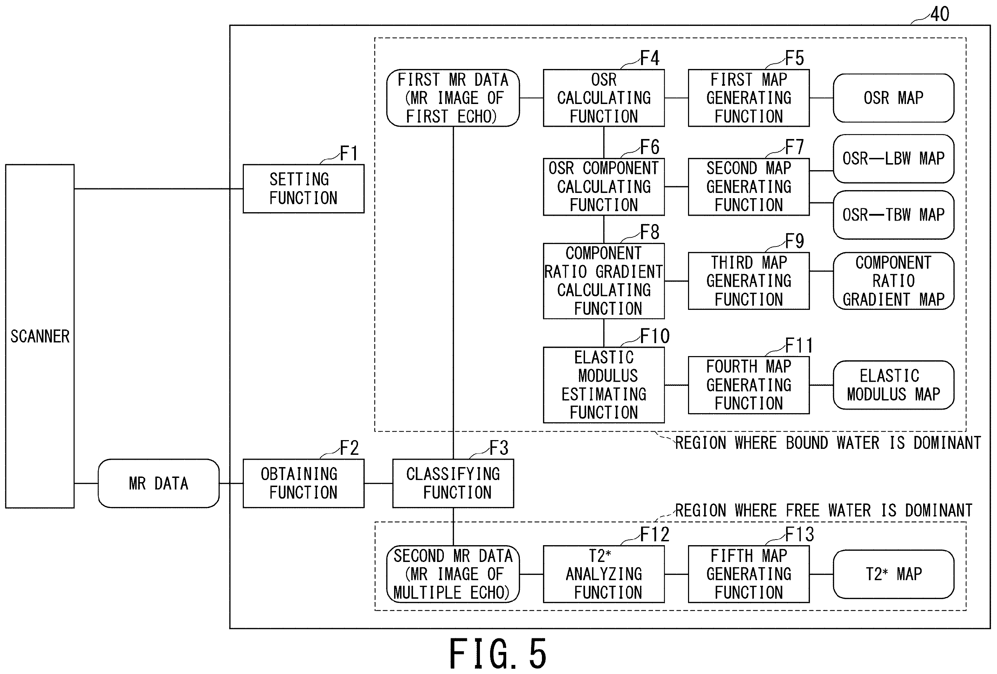

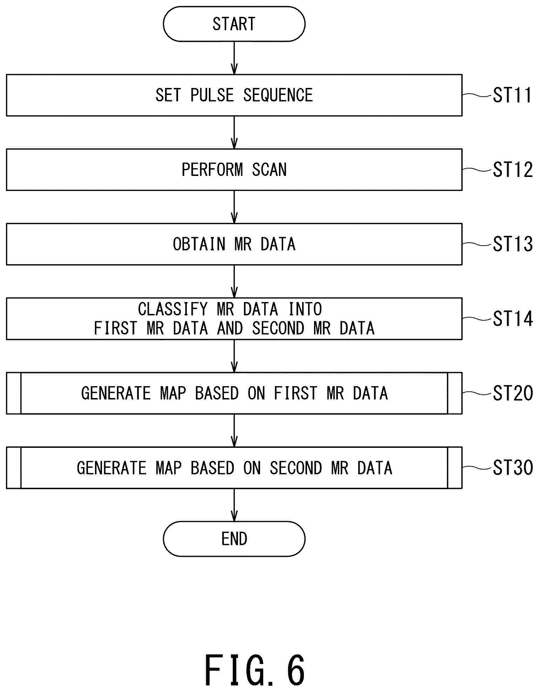

Fig. 5 is a block diagram showing the processing circuitry 40 of the MRI apparatus 1 according to a first embodiment. The processing circuitry 40 in the first embodiment executes: a setting function F1, an obtaining function F2, a classifying function F3, an OSR calculating function F4, a first map generating function F5, an OSR component calculating function F6, a second map generating function F7, a component ratio gradient calculating function F8, a third map generating function F9, an elastic modulus estimating function F10, a fourth map generating function F11, a T2* analyzing function F12, and a fifth map generating function F13. An operation example of the MRI apparatus 1 according to the first embodiment will be described, with reference to the flowchart in Fig. 6.

In step ST11, the setting function F1 sets a pulse sequence for acquiring MR data.

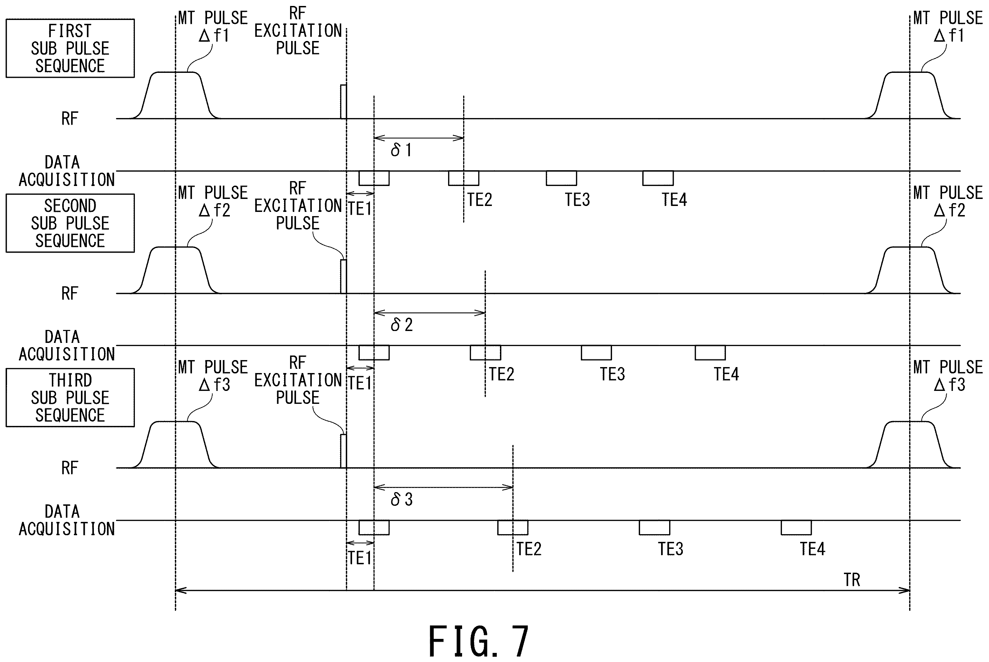

Fig. 7 is a sequence chart showing an example of timing of an RF pulse application and a data acquisition in the pulse sequence according to the embodiment. The pulse sequence is structured with a plurality of sub pulse sequences. Although Fig. 7 shows the pulse sequence structured with three sub pulse sequences, namely first, second, and third sub pulse sequences, the quantity of the sub pulse sequences is not limited. For example, the pulse sequence may be structured with N sub pulse sequences including the first to an N-th sub pulse sequences (where N is a natural number of 2 or larger).

The plurality of sub pulse sequences are for acquiring, by using a UTE sequence, MR data corresponding to each of a plurality of echo signals occurring after applying at least one MT pulse and RF pulses to the object. In other words, the UTE sequence in the present embodiment is for acquiring the data with a multi echo scheme. Fig. 7 shows a four-echo UTE sequence; however, the quantity of the multiple echoes is not particularly limited, as long as the quantity is two or more. The quantity may be four or more.

The UTE sequence is, for example, a sequence capable, by using a Gradient Echo (GRE) sequence, of setting an extremely short echo time (TE) which is from the application of an RF excitation pulse to an MR data acquisition corresponding to an initial echo signal, and thus makes it possible to more clearly render a firm tissue or a tissue with little moisture, such as a bone, a tendon, or a lung tissue.

The MR data acquired in the first TE of the plurality of TEs, i.e., in the echo time corresponding to the initial echo signal after the application of the RF pulse, will be used for both types of analyses, namely, analyzing a region where bound water is dominant and analyzing a region where free water is dominant.

The MR data acquired in the second and later TEs among the plurality of TEs, i.e., in the echo times corresponding to the second and later echo signals after the application of the RF pulse, will be used for analyzing the region where free water is dominant, together with the MR data acquired in the first TE. In other words, in Repetition Time (TR) of the sub pulse sequences, an RF excitation pulse for the data acquisition with the first echo, a data acquisition phase of the first echo, and a spoiler are used in common.

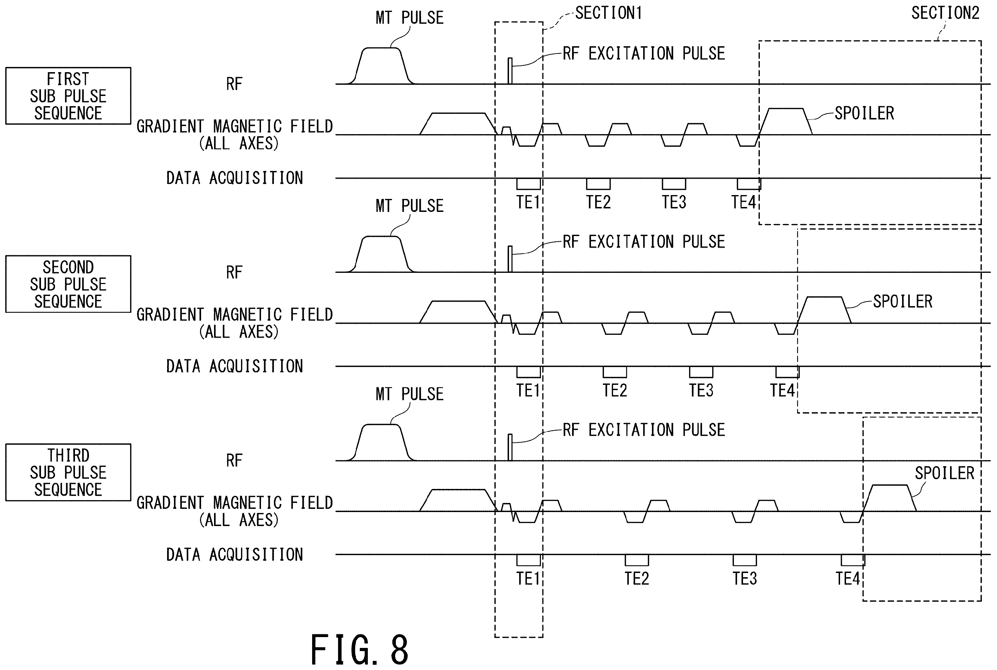

Fig. 8 is a drawing for explaining improvement of a data acquisition ratio achieved by a pulse sequence example according to an embodiment. As shown in Fig. 8, Section 1 denotes the duration from an RF excitation pulse for the data acquisition with the first echo using an MT pulse, to completion of the MR data acquisition. Section 2 includes application of a spoiler gradient magnetic field pulse.

In Section 2, each of the sub pulse sequences is provided, after the application of the spoiler gradient magnetic field pulse, with an MR signal recovery time, which is equal to or longer than a prescribed length and is for returning an atomic nucleus to an original energy level. After that, the next repetition time (TR) starts. With this configuration, it is possible to guarantee image quality and a desired level of image contrast of the MR image. Also, the recovery time may vary among the sub pulse sequences.

As described above, Section 1 and Section 2 are used in common to: a data acquisition phase with the first echo which uses the MT pulse and is for analyzing the region where bound water is dominant; and a multi echo data acquisition phase for analyzing the region where free water is dominant. Accordingly, data acquisition efficiency is expected to greatly improve, as compared to the situation where the data is acquired each with a single scan, in the data acquisition phase with the first echo using the MT pulse and in the multi echo data acquisition phase.

For example, when the single scan is performed for each type, the data acquisition scan using the MT pulse would take an approximately 5-minute scan period, and the multi echo data acquisition scan would take an approximately 10-minute scan period, which would require approximately 15 minutes in total. In contrast, by using the pulse sequence according to the embodiment, the scan period for acquiring equivalent data would be approximately 10 minutes. Thus, it is possible to shorten the scan period to approximately three quarters of the scan period when the single scan is performed for each type.

Further, in a conventional UTE sequence for a T2* analysis, for example, it would be necessary to carry out the data acquisition while varying the first TE of the plurality of TEs among the plurality of sub pulse sequences, in order to guarantee data in a necessary and sufficient amount to express an decay of an MR signal having an extremely short T2* component of less than 1 ms, for example.

In contrast, in the pulse sequence according to the embodiment, for example, the data acquisition phase with the first echo using the MT pulse, i.e., an Off-resonance Saturation (OS) data acquisition phase using the MT pulse, can acquire data of the extremely short T2* component less than 1 ms.

For example, when data acquisition corresponding to 20 echoes is to be performed while the TR is 20 ms, and the quantity of the multiple echoes is 5, in a conventional UTE sequence for a T2* analysis, the first TE of the plurality of TEs is set so as to vary among the plurality of sub pulse sequences as follows: For example, a plurality of TEs in the first sub pulse sequence may be set to 0.18, 2.61, 5.06, 7.46, and 9.89; a plurality of TEs in the second sub pulse sequence may be set to 0.40, 2.83, 5.26, 7.68, and 10.11; a plurality of TEs in the third sub pulse sequence may be set to 0.80, 3.23, 5.66, 8.08, and 10.51; and a plurality of TEs in the fourth sub pulse sequence may be set to 1.6, 4.03, 6.46, 8.88, and 11.31.

In contrast, in the pulse sequence according to the embodiment, by setting the first TE of the plurality of TEs to a prescribed TE in each of the plurality of sub pulse sequences as follows, it is possible to reduce the quantity of the sub pulse sequences. For example, when data acquisition corresponding to 20 echoes is to be performed while the TR is 20 ms, and the quantity of the multiple echoes is 5 similarly to the above example, a plurality of TEs in the first sub pulse sequence may be set to 0.18, 2.61, 5.06, 7.46, and 9.89; a plurality of TEs in the second sub pulse sequence may be set to 0.18, 2.83, 5.26, 7.68, and 10.11; and a plurality of TEs in the third sub pulse sequence may be set to 0.18, 4.03, 6.46, 8.88, and 11.31. In this situation, it is possible to reduce the quantity of the sub pulse sequences to three quarters of that in the conventional example and to shorten the scan period at least to three quarters. In this situation, the plurality of TEs are not limited to those in this example and may be set as appropriate.

Further, the quantity of the multiple echoes may vary among the plurality of sub pulse sequences. Further, the TR may be set as appropriate. By reducing the quantity of the multiple echoes and setting the TR appropriately, while keeping the capability to acquire the data for the T2* analysis, it is possible to further shorten the scan period.

As described above, in the pulse sequence according to the embodiment, by performing the multi echo data acquisition together with an Off-resonance Saturation (OS) data acquisition in each repetition time TR, the data for an OS analysis and the data for the T2* analysis are acquired in the single sub pulse sequence. As described above, as compared to the sequence by which the data for the OS analysis and the data for the T2* analysis are acquired separately, the data acquisition efficiency is improved, and it is also possible to obtain, with a higher level of precision, information about regions that are difficult to be measured with a conventional UTE sequence for the T2* analysis, i.e., components originating from bound water. In other words, it is possible to realize the data acquisition for the T2* analysis in a wide dynamic range of $10^{-5}$ s to 1 s.

With respect to each TR in the sub pulse sequences, it is possible to set imaging conditions such as a flip angle $\theta$ of the MT pulse, an off-resonance frequency, a TE, an echo space, and the like. Also, as the imaging conditions, the quantity of the multiple echoes, a TR, the number of times of addition, a matrix size to be used for setting a resolution, a slice thickness, a Field Of View (FOV), and/or the like may be set. The imaging conditions for the pulse sequence are set through, for example, a user operation performed via the input interface 43 or reading the imaging conditions stored in advance in the memory 41.

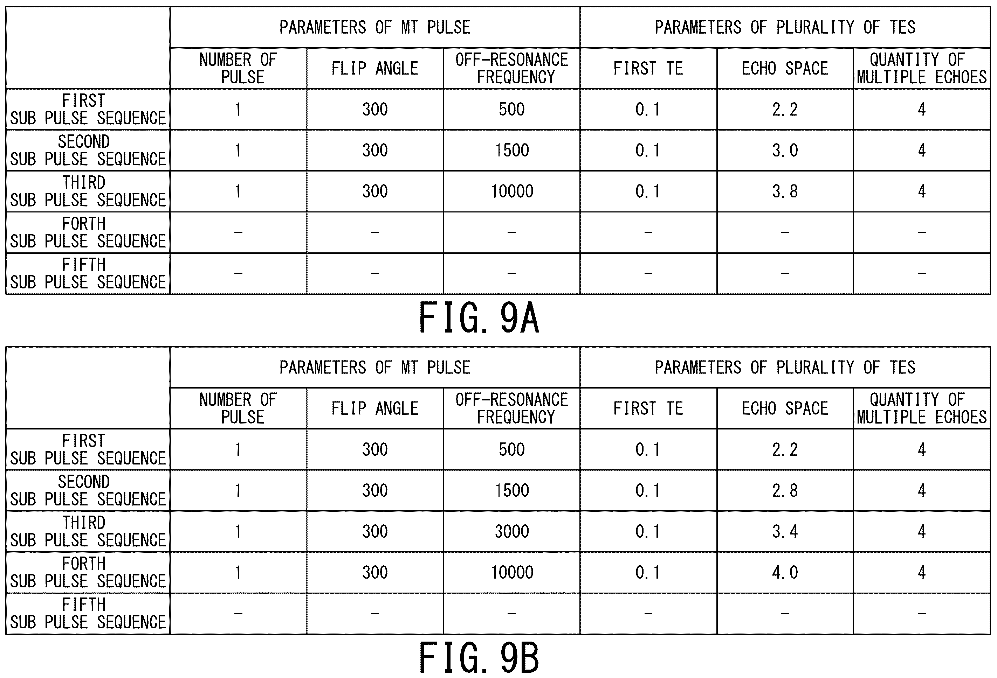

Fig. 9A and Fig. 9B are drawings showing setting examples of imaging conditions for a pulse sequence according to an embodiment. As shown in the setting examples in Fig. 9A and Fig. 9B for obtaining information about a plurality of living body tissues or information having a higher level of precision, the following items may be displayed on a GUI in such a manner that each item can be set with respect to each TR in the sub pulse sequences: the quantity of pulses in the MT pulse, a flip angle $\theta$, an off-resonance frequency, the first TE of the plurality of TEs, an echo space, and the quantity of the multiple echoes. In addition, it may also be possible to set the quantity of the sub pulse sequences. For example, Fig. 9A indicates that the quantity of the sub pulse sequences is 3. Fig. 9B indicates that the quantity of the sub pulse sequences is 4. The imaging conditions that can be set on the GUI are not limited to these examples and may be a part of the imaging conditions shown in Fig. 9A and Fig. 9B or may include other imaging conditions that are not shown in Fig. 9A or Fig. 9B.

Fig. 9A shows a typical setting example. Fig. 9B shows a setting example for obtaining the information about a plurality of living body tissues or the information having a higher level of precision. For example, by increasing the quantity of the sub pulse sequences and increasing the number of settings in which the off-resonance frequency of the MT pulse or the echo space is varied, it is possible to obtain the information about a plurality of living body tissues or the information having a higher level of precision.

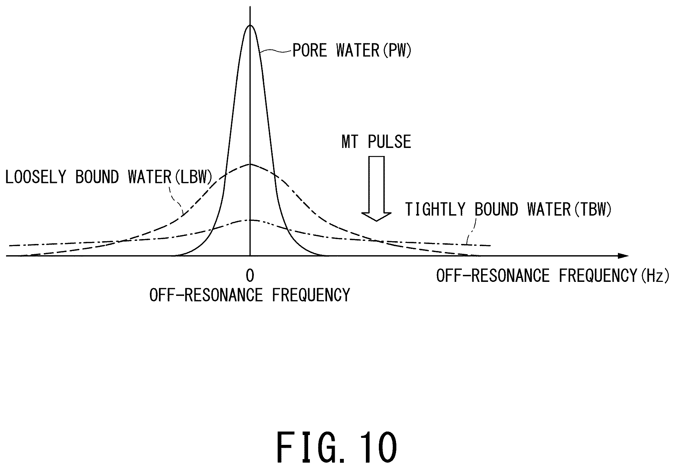

In the pulse sequence according to the present embodiment, the off-resonance frequencies of the MT pulse are mutually different among the plurality of sub pulse sequences. Fig. 10 is a drawing for explaining Magnetization Transfer (MT) of pore water, loosely bound water, and tightly bound water. By making use of differences in an MT effect caused by varying the off-resonance frequency of the MT pulse, it is possible to enhance contrast among tightly bound water, loosely bound water, and pore water. For example, T2* values of the loosely bound water are approximately 0.2 ms to 0.4 ms; T2* values of the tightly bound water are 10 $\mu$s or shorter; and T2* values of the pore water are approximately 1 ms to 5 ms.

The data acquired in the first TE of the plurality of TEs is used as the data for the OS analysis. Thus, it is desirable that the data is acquired so as to be effected only by the MT pulse among the sub pulse sequences. In other words, it is desirable that the first TE of the plurality of TEs is the same in all of the plurality of sub pulse sequences. Alternatively, the first TE of the plurality of TEs may be different among the plurality of sub pulse sequences. Moreover, one of the sub pulse sequences other than the first sub pulse sequence may be a sub pulse sequence for acquiring only the data for the T2* analysis without acquiring the data for the OS analysis. In that situation, in the first TE of the plurality of TEs, no MR data is acquired.

In addition, the data acquired in the first TE is used as the data for the T2* analysis. The data acquired in the first TE is effected by the MT pulse; however, for example, if there is a sub pulse sequence by which an MT pulse is applied at an off-resonance frequency sufficiently away from an on-resonance frequency to an extent that the MT pulse is presumed to be ineffective, it is possible to make a correction to reduce the effect imposed by the MT pulse.

Further, as the data for the T2* analysis, the data acquired in the second and later TEs among the plurality of TEs is also used. In order to minimize the effect of the MT pulse returning to original magnetization over the course of time, it is desirable that the setting function F1 sets the pulse sequence in such a manner that the lower the off-resonance frequency is, the larger the echo space is, which is an acquisition interval of each of the plurality of echo signals. For example, in Fig. 7, the magnitude relationship among the off-resonance frequencies of the first, second, and third sub pulse sequences is expressed as $\Delta f1 > \Delta f2 > \Delta f3$. The magnitude relationship among the echo spaces of the first, second, and third pulse sequences is expressed as $\delta1 < \delta2 < \delta3$.

Further, it is desirable that the second and later TEs of the plurality of TEs are mutually different among the plurality of sub pulse sequences. When the second and later TEs are mutually different among the plurality of sub pulse sequences, because a larger number of TEs are used for an analysis to calculate a T2* value, which is different for each tissue in a living body, the precision level of the T2* analysis is improved.

As described above, by using the pulse sequence according to the embodiment, it is possible to obtain the data for the OS analysis and the data for the T2* analysis with respect to a certain voxel in a k-space. Further, by repeating similar pulse sequences while varying an encoding amount, it is possible to obtain the data for the OS analysis and the data for the T2* analysis with respect to other voxels in the k-space. It is also acceptable to acquire the data in the k-space by varying the encoding amount, radially for a two-dimensional (2D) implementation and by filling the k-space in the manner of a Koosh ball for a three-dimensional (3D) implementation.

Returning to the description of Fig. 6, in step ST12 of Fig. 6, the scanner performs a scan. In other words, the scanner applies, to the object, the pulse sequence that has been set so as to acquire the MR data corresponding to each of the plurality of echo signals in each of the plurality of sub pulse sequences. The scanner acquires the MR data while targeting a tissue in the living body of the object including free water and bound water as components thereof. Examples of the tissue in the living body include tissues of a deep radial cartilage, a calcified cartilage, a meniscus, a ligament, a tendon, a cortical bone, a lung, the cranial nervous system, the central nervous system, and the peripheral nervous system.

In step ST13, the obtaining function F2 (see Fig. 5) obtains the MR data acquired by using the pulse sequence.

In step ST14, the classifying function F3 classifies the MR data into first MR data corresponding to each of the mutually-different off-resonance frequencies; and second MR data corresponding to each of mutually-different TEs. The first MR data are a plurality of data acquired in the first TE of the plurality of TEs in the UTE sequence, with respect to each TR in the sub pulse sequences. The second MR data are a plurality of data acquired in the plurality of TEs in the UTE sequence, i.e., with the multiple echoes in the UTE sequence, with respect to each TR in the sub pulse sequences.

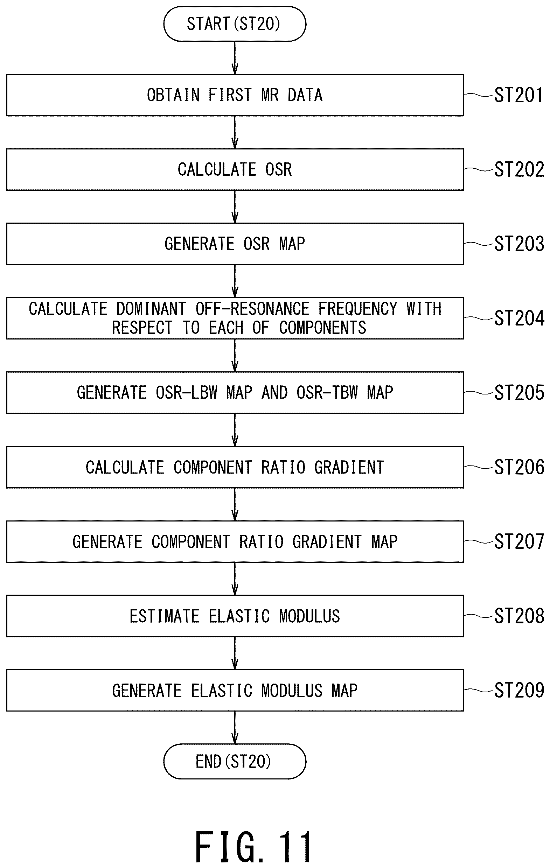

In step ST20, based on the first MR data, all of various types of maps may be generated or a part thereof may be generated. In other words, it is sufficient when the processing circuitry 40 includes one or more functions corresponding to the maps to be generated, from among the first map generating function F5, the second map generating function F7, the third map generating function F9, the fourth map generating function F11, and the fifth map generating function F13. Fig. 11 is a flowchart that specifically shows an operation example in step ST20 performed by the MRI apparatus 1 according to the first embodiment.

In step ST201, the OSR calculating function F4 obtains the first MR data.

In step ST202, the OSR calculating function F4 calculates an Off-resonance Saturation Ratio (OSR) with respect to each of the mutually-different off-resonance frequencies, based on the first MR data. It is possible to express an OSR $(\theta, \Delta f)$ exhibited by an MT pulse having a flip angle $\theta$ and an off-resonance frequency $\Delta f$, as shown in Expression 1:

$$\text{OSR } (\theta, \Delta f) = (S0 - Ssat (\theta, \Delta f)) / S0 \quad (\text{Expression 1})$$

In the above, the symbol $\theta$ denotes the flip angle of the MT pulse, i.e., the intensity of the MT pulse. The element $\Delta f$ denotes a frequency shift from an on-resonance frequency, i.e., an off-resonance frequency. The element S0 denotes an average signal intensity obtained in the state where the MT pulse is not applied, i.e., in the state where the flip angle $\theta = 0$ and the off-resonance frequency $\Delta f = 0$ are true. The element $Ssat(\theta, \Delta f)$ denotes an average signal intensity obtained in the state where an MT pulse having a flip angle $\theta$ and an off-resonance frequency $\Delta f$ is applied. For being saturated by a saturation effect, $Ssat(\theta, \Delta f)$ represents a lower signal intensity than S0.

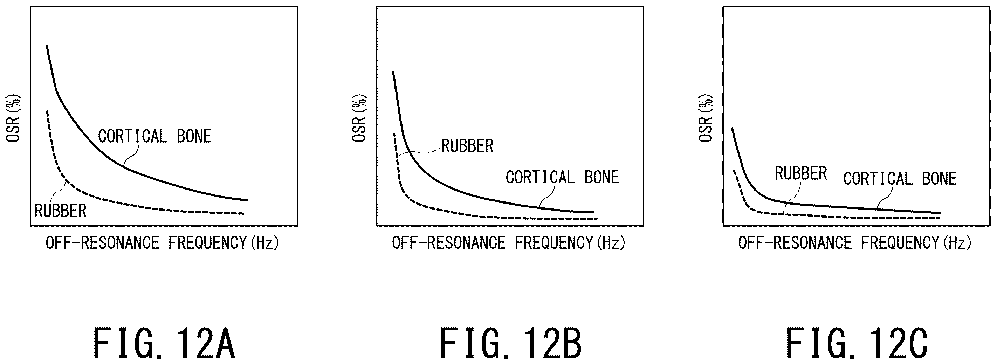

Fig. 12A to Fig. 12C are graphs showing examples of off-resonance frequencies vs OSR characteristics of a cortical bone and rubber, with respect to mutually-different MT pulse intensities. The MT pulse intensities are proportional to the flip angles of the MT pulse and become smaller in the order of Fig. 12A, Fig. 12B, and Fig. 12C. The higher the MT

**EP 4 787 005 A2**

pulse intensity is, the larger the OSR is. The higher the off-resonance frequency is, the smaller the OSR is. This tendency is more significant in the cortical bone than in the rubber. Because the rubber has no proton pool such as mineral bound water or protons of collagen, which contributes to the OSRs of the cortical bone, the OSRs of the rubber are lower than the OSRs of the cortical bone across the board.

In step ST203, the first map generating function F5 generates an OSR map expressing, with pixel values, OSRs corresponding to the mutually-different off-resonance frequencies.

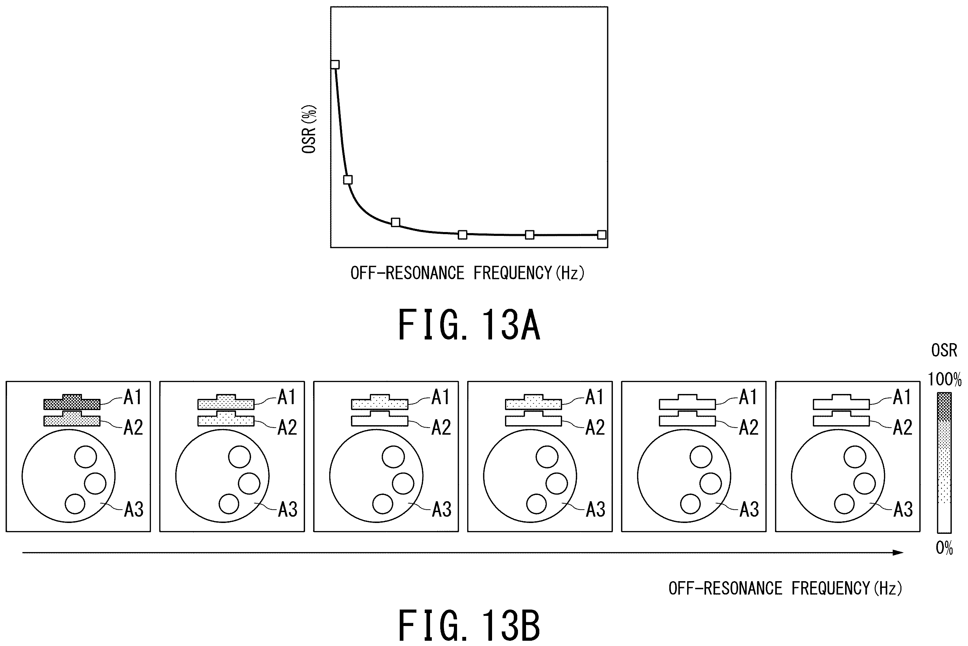

Fig. 13A is a graph showing a relationship between off-resonance frequencies and OSRs with respect to a specific voxel. Fig. 13B is a map image expressing, as pixel values, OSRs corresponding to off-resonance frequencies, with respect to phantoms A1, A2, and A3 having mutually-different elastic moduli.

In step ST204, the OSR component calculating function F6 calculates a dominant off-resonance frequency with respect to each of the components of a tissue in a living body, based on the OSR of each of the mutually-different off-resonance frequencies. In this situation, the components of the tissue in the living body include components related to loosely bound water and components related to tightly bound water.

More specifically, the OSR component calculating function F6 isolates and calculates the dominant off-resonance frequency with respect to each of the components of the tissue in the living body, by fitting an exponential function model to a binding model of all the components of the tissue in the living body.

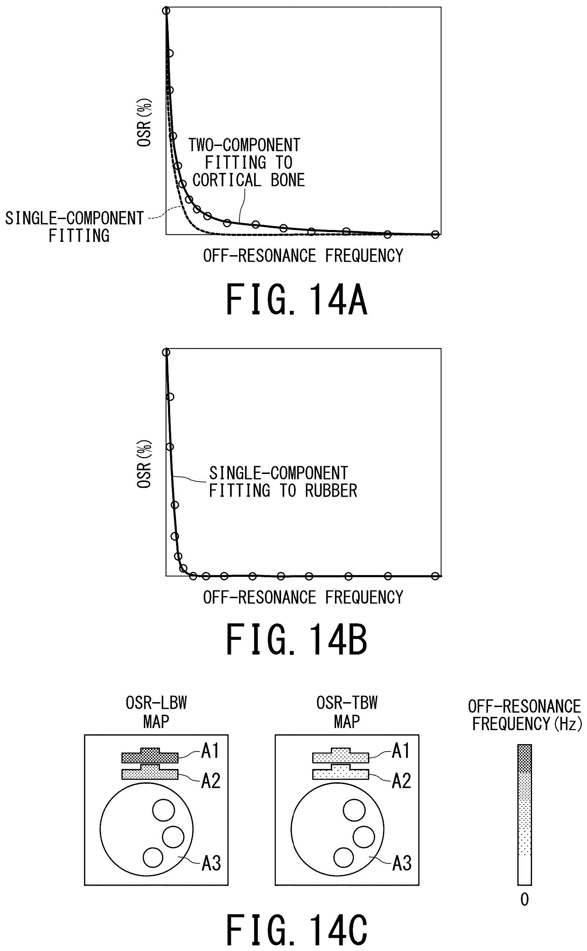

Fig. 14A presents a graph showing an example in which an exponential function model having a single component and an exponential function model having two components are fitted to off-resonance frequencies vs OSR characteristics with respect to a cortical bone. With respect to the cortical bone, a fitting error was larger when the single-component fitting was performed than when the two-component fitting was performed. Fig. 14B presents a graph showing a fitting example of OSRs with respect to rubber. With respect to the rubber, the fitting had a high level of precision even when the single-component fitting was performed. Although an example will be described below by using a binding model with two components, namely, loosely bound water and tightly bound water, the components of a tissue in a living body may be multiple components of three or more. Even when there are multiple components of three or more, it is possible to isolate and calculate an off-resonance frequency with respect to each of the components of the tissue in the living body.

As indicated in Expression 2, an exponential decay $S(\Delta f)$ of OSRs with respect to off-resonance frequencies $\Delta f$ can be separated into $\alpha^*\exp(-\Delta f/\beta)$ representing the OSR for the loosely bound water, $\gamma^*\exp(-\Delta f/\delta)$ representing the OSR for the tightly bound water, and a noise component $\varepsilon$. Further, by performing a curve fitting using the two-component exponential function model, it is possible to calculate parameters in Expression 2, namely, $\alpha$, $\beta$, $\gamma$, and $\delta$. In this situation, a dominant off-resonance frequency of the components of the loosely bound water is calculated as $\beta$. A dominant off-resonance frequency of the components of the tightly bound water is calculated as $\delta$.

$$S(\Delta f) = \alpha * \exp(-\Delta f/\beta) + \gamma * \exp(-\Delta f/\delta) + \varepsilon \quad \text{(Expression 2)}$$

In step ST205, the second map generating function F7 generates an OSR component map expressing, with pixel values, the dominant off-resonance frequency with respect to each of the components of the tissue in the living body.

With respect to the same phantom as that in Fig. 13B, Fig. 14C presents a map image separated into two components, namely, an OSR-LBW map expressing, with pixel values, the off-resonance frequencies of the components related to the loosely bound water; and an OSR-TBW map expressing, with pixel values, the off-resonance frequencies of the components related to the tightly bound water. In other words, the map image separately indicates the loosely bound water, i.e., $\alpha^*\exp(-\Delta f/\beta)$ representing the OSR with respect to an off-resonance frequency close to an on-resonance frequency; and the tightly bound water, i.e., $\gamma^*\exp(-\Delta f/\delta)$ representing the OSR with respect to an off-resonance frequency away from the on-resonance frequency. In this manner, in step ST205, the map image is generated with respect to each of the components of the tissue in the living body.

In step ST206, the component ratio gradient calculating function F8 calculates a component ratio gradient based on the dominant off-resonance frequency with respect to each of the components of the tissue in the living body.

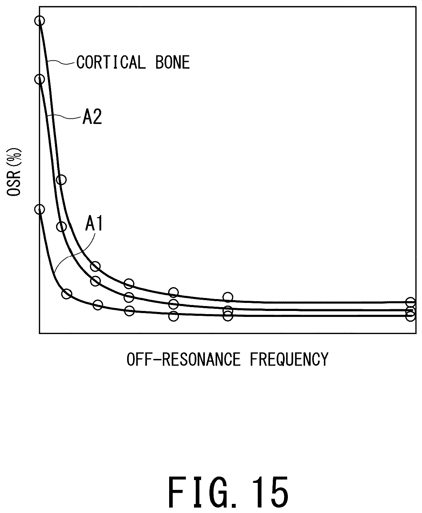

Fig. 15 is a graph showing a relationship between off-resonance frequencies and OSRs in a specific voxel, with respect to the two types of phantoms A1 and A2 and a cortical bone. The two types of phantoms A1 and A2 are phantoms having mutually-different elastic moduli. The elastic modulus of the phantom A1 is approximately twice as high as the elastic modulus of the phantom A2. In other words, the phantom A1 is firmer than the phantom A2.

With respect to each of the two types of phantoms A1 and A2 and the cortical bone in Fig. 15, the OSRs are separated as $\alpha^*\exp(-\Delta f/\beta)$ representing the OSR for the loosely bound water and $\gamma^*\exp(-\Delta f/\delta)$ representing the OSR for the tightly bound water according to step ST204, and subsequently a component ratio is calculated by calculating values of $\alpha$ and $\gamma$ so that the sum of the components related to the loosely bound water and the components related to the tightly bound water is equal to 100%. In other words, when the component ratio related to the loosely bound water corresponding to the off-resonance frequency $\beta$ is calculated, through a curve fitting process, as $\alpha(\%)$, the component ratio y(%) related to the

**10**

tightly bound water corresponding to the off-resonance frequency $\delta$ is calculated as $\gamma(\%) = 100 - \alpha\,(\%)$.

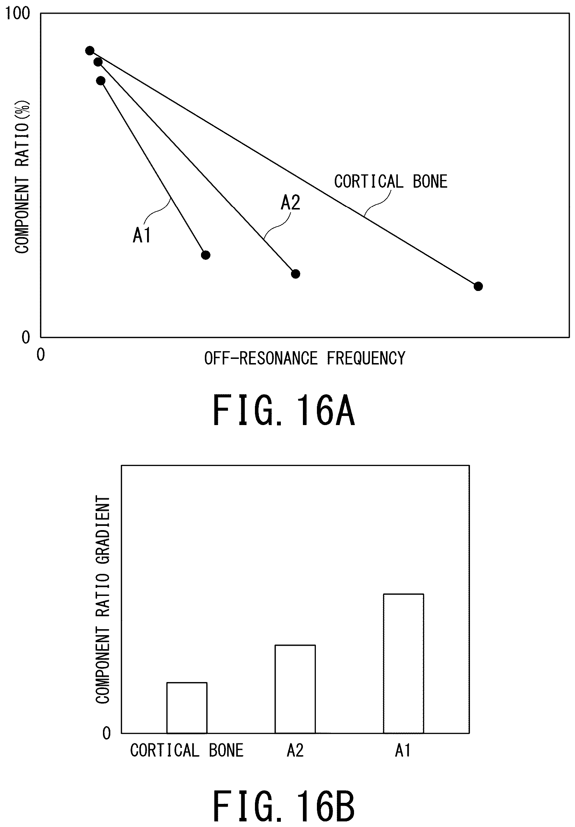

Fig. 16A is a graph showing a relationship between off-resonance frequencies and component ratios in a specific voxel with respect to the two types of phantoms and the cortical bone in Fig. 15. Fig. 16B is a graph showing component ratio gradients calculated based on the relationship in Fig. 16A. The component ratio gradients each denote a slope of the component ratio with respect to the off-resonance frequency. The larger the difference is between the dominant off-resonance frequency $\beta$ of the components of the loosely bound water and the dominant off-resonance frequency $\delta$ of the components of the tightly bound water, the gentler the component ratio gradient is.

In this situation, it is possible to consider that the component ratio gradients relatively express elastic moduli of the two types of phantoms A1 and A2 and the cortical bone.

Thus, in step ST207, the third map generating function F9 generates a component ratio gradient map expressing, with pixel values, a component ratio gradient with respect to each of the components of the tissue in the living body.

Further, in step ST208, the elastic modulus estimating function F10 estimates an elastic modulus with respect to each of the components of the tissue in the living body, based on the component ratio gradients. In the first embodiment, the elastic modulus estimating function F10 estimates the elastic modulus with respect to each of the components of the tissue in the living body, based on the first MR data.

Because elastic moduli are indices expressing firmness as a primary physical index, when an elastic modulus is estimated, it is possible to estimate a bone density based on a database regarding a relationship between bone densities and elastic moduli. Further, if there is a database showing a correlation between bone diseases and elastic moduli, it is also possible to estimate a disease, based on the elastic modulus, i.e., information about the firmness, in the case of a lesion.

In step ST209, the fourth map generating function F11 generates an elastic modulus map expressing, with pixel values, the elastic modulus with respect to each of the components of the tissue in the living body.

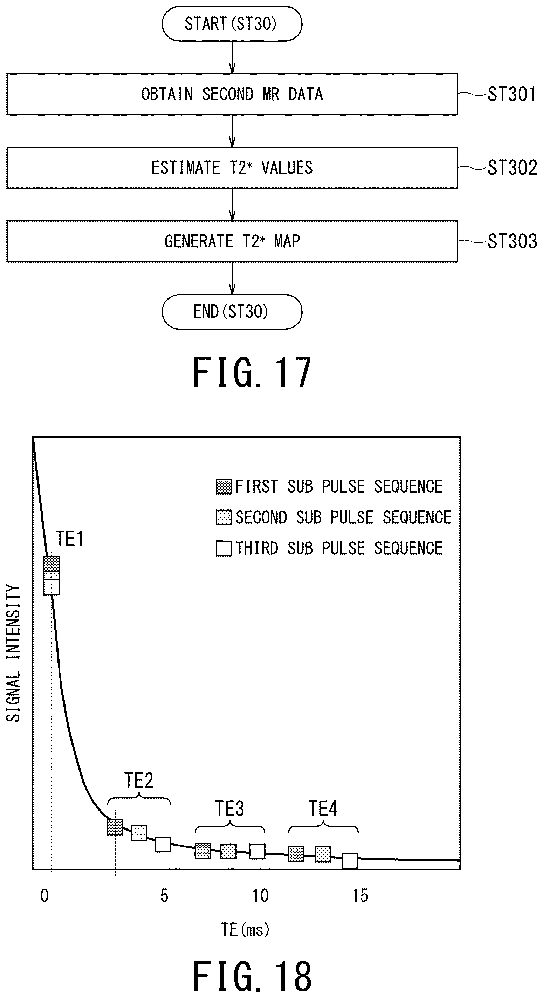

Returning to the description of Fig. 6, in step ST30 in Fig. 6, a map is generated based on the second MR data. Fig. 17 is a flowchart specifically showing an operation example in step ST30 performed by the MRI apparatus 1 according to the first embodiment.

In step ST301, the T2* analyzing function F12 obtains the second MR data.

In step ST302, the T2* analyzing function F12 estimates T2* values based on the second MR data. Fig. 18 is a graph of a T2* decay curve exhibited by a UTE sequence. In step ST11, when the second and later TEs are varied among the plurality of sub pulse sequences, because a larger number of TEs are used for the analysis to calculate the T2* values, the precision level of the T2* analysis is improved.

In step ST303, the fifth map generating function F13 generates a T2* map expressing the T2* values with pixel values.

As mentioned earlier, the MRI apparatus 1 according to the first embodiment is expected to improve the data acquisition efficiency, while realizing the data acquisition for the T2* analysis in the wider dynamic range such as $10^{-5}$ s to 1 s. In addition, because the simultaneous data acquisition of the data for the OS analysis and the data for the T2* analysis is possible while using the plurality of living body tissues as subjects of the observation, it is possible to improve the data acquisition efficiency and to also evaluate special mutual interactions in which mechanical, biochemical, and metabolic mutual interactions continuously occur in the plurality of living body tissues. With regard to tissue properties of the subject of the measurement, it is possible, in the wide dynamic range, to systematically evaluate the information about the free water and the information about the bound water and to make the quantitative evaluation when multiple types of bound water are present.

For example, for osteoporosis, it is known that clinical evaluations of both bones and tendons are important. In relation to this, tendons and bones have special mutual interactions where mechanical, biochemical, and metabolic mutual interactions continuously occur. A decrease in the bone mass in osteoporosis and in osteopenia, which is a preceding stage thereof, is relevant to degradation in the quality of tendons. In this regard, according to the first embodiment, it is possible to make a systematic evaluation including both polymer components and water components in a tissue having an extremely short T2* value, such as a deep radial cartilage, a calcified cartilage, a meniscus, a ligament/tendon, or a cortical bone. Further, the capability to make the systematic evaluation contributes to early detections, diagnosis assistance, and treatment effect monitoring for osteoarthritis, osteoporosis, osteogenesis imperfecta, and the like.

(An information processing apparatus)

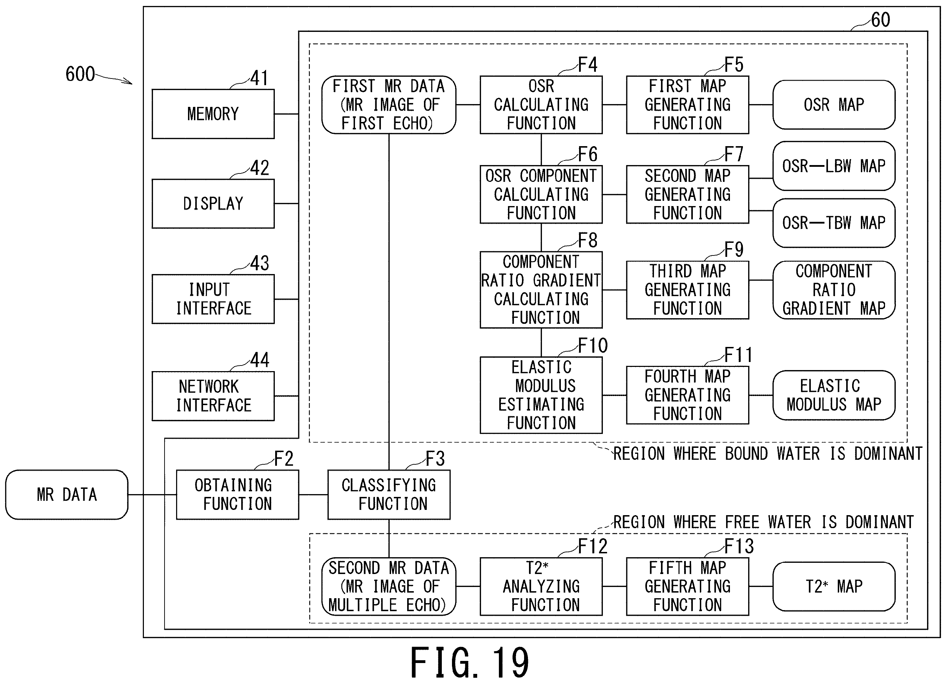

Fig. 19 is a block diagram showing an overall configuration example of an information processing apparatus 600 according to the first embodiment. The information processing apparatus 600 includes processing circuitry 60, a memory 41, a display 42, an input interface 43, and a network interface 44. The processing circuitry 60 of the information processing apparatus 600 according to the first embodiment is different from the processing circuitry 40 of the MRI apparatus 1 according to the first embodiment for not including the setting function F1. Separately from the scanner of the MRI apparatus 1, the processing circuitry 60 of the information processing apparatus 600 is able to perform the processes in step ST13 and thereafter in the flowchart of Fig. 6, similarly to the processing circuitry 40 of the MRI apparatus 1. Because the other various types of functions are substantially equivalent, duplicate descriptions thereof will be omitted.

More specifically, in step ST13, in the information processing apparatus 600, the obtaining function F2 obtains the MR data acquired by using the pulse sequence including the plurality of sub pulse sequences for acquiring, by using a UTE sequence, the MR data corresponding to each of the plurality of echo signals occurring after applying the MT pulse and the RF pulse to the object. In this situation, the MT pulse is applied to the object by varying the off-resonance frequencies thereof among the plurality of sub pulse sequences. For example, the MR data is obtained via the memory 41, the input interface 43, and the network interface 44.

(Second Embodiment)

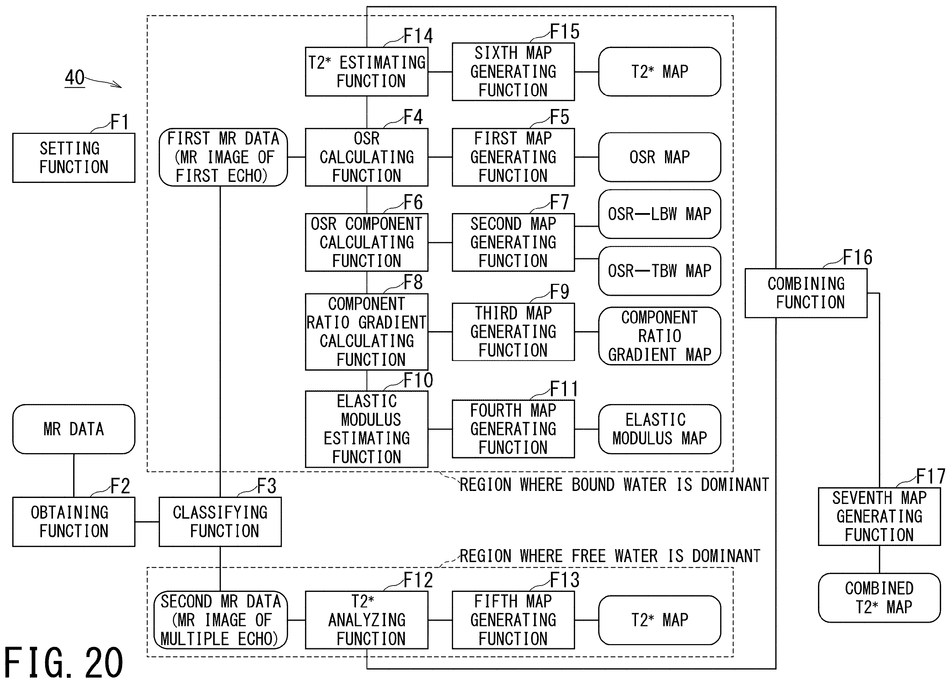

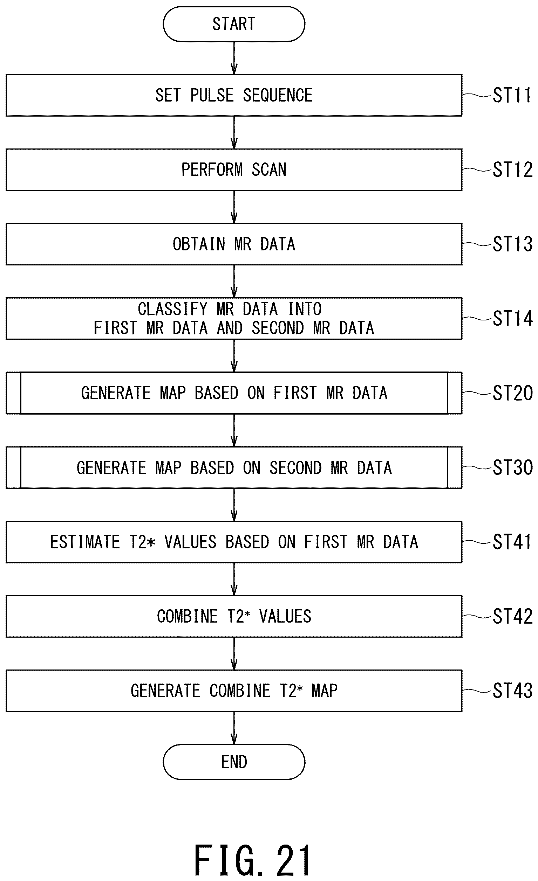

Fig. 20 is a block diagram showing the processing circuitry 40 of the MRI apparatus 1 according to a second embodiment. The second embodiment is different from the first embodiment in that the processing circuitry 40 further executes a T2* estimating function F14, a sixth map generating function F15, a combining function F16, and a seventh map generating function F17. An operation example of the MRI apparatus 1 according to the second embodiment will be described, with reference to the flowchart in Fig. 21.

In step ST41, the T2* estimating function F14 estimates first T2* values based on the first MR data. It is possible to estimate the first T2* values by using a conversion formula based on a correlation between a physical index such as OSC values and T2* values or a publicly known method.

After step ST41, the sixth map generating function F15 may generate a T2* map (a sixth map) based on the first T2* values.

In step ST42, the combining function F16 combines the first T2* values with the second T2* values. In this situation, the second T2* values are the T2* values estimated by the T2* analyzing function F12 based on the second MR data in step ST302 of Fig. 17. By combining the first T2* values with the second T2* values, it is possible to calculate T2* values in a wide dynamic range such as $10^{-5}$ s to 1 s, for example.

In step ST43, the seventh map generating function F17 generates a combined T2* map (a seventh map) expressing the combined T2* values with pixel values, based on the first T2* values and the second T2* values.

(A Modification Example of Second Embodiment)

It is acceptable when the elastic modulus estimating function F10 estimates an elastic modulus with respect to each of the components of a tissue in a living body based on at least one of the first MR data and the second MR data. In a modification example of the second embodiment, the elastic modulus estimating function F10 estimates the elastic modulus with respect to each of the components of the tissue in the living body, based on both the first MR data and the second MR data.

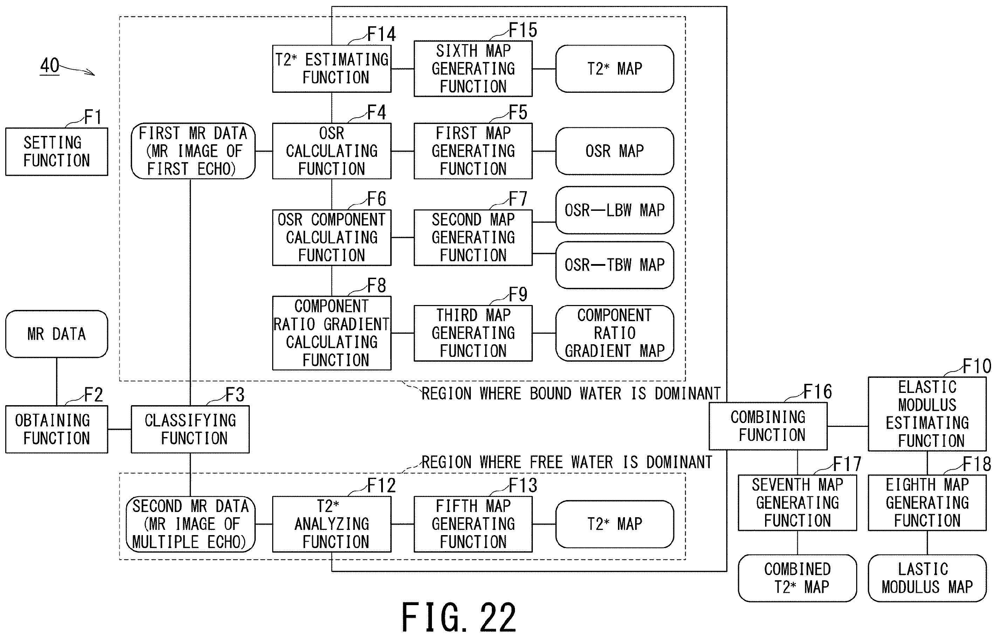

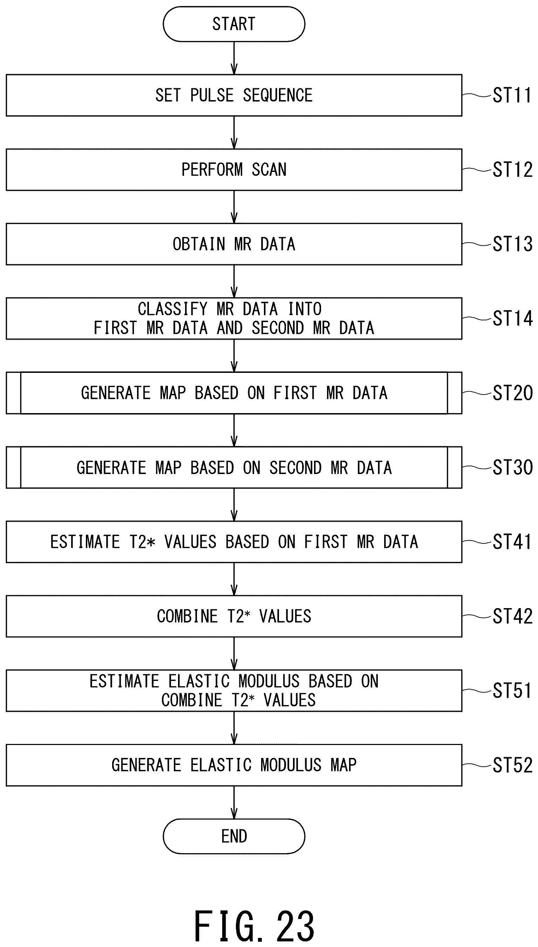

Fig. 22 is a block diagram showing the processing circuitry 40 of the MRI apparatus 1 according to the modification example of the second embodiment. The modification example of the second embodiment is different from the second embodiment in that the processing circuitry 40 executes the elastic modulus estimating function F10 after the processing of the combining function F16 instead of after the processing of the component ratio gradient calculating function F8 and further executes an eighth map generating function F18. An operation example of the MRI apparatus 1 according to the modification example of the second embodiment will be described, with reference to the flowchart in Fig. 23. In step ST42, the combining function F16 performs the process of combining the first T2* values estimated based on the first MR data with the second T2* values estimated based on the second MR data. Subsequently, the process proceeds to step ST51.

In step ST51, the elastic modulus estimating function F10 estimates an elastic modulus with respect to each of the components of the tissue in the living body with a wide dynamic range, based on the first T2* values and the second T2* values. In this situation, the first T2* values and the second T2* values include T2* values of both of the components, namely the free water and the bound water. In the modification example of the second embodiment, the elastic modulus estimating function F10 estimates the elastic modulus with respect to each of the components of the tissue in the living body, based on both the first MR data and the second MR data.

Alternatively, the elastic modulus estimating function F10 is also capable of estimating an elastic modulus with respect to each of the components of the tissue in the living body, based on the second MR data; however, when only the second MR data is used, because a component analysis is performed by using the free water as a principal element, effects of the components bound to biopolymers are not taken into consideration. For this reason, it is desirable to estimate the elastic modulus with respect to each of the components of the tissue in the living body, based on both the first MR data and the second MR data.

In step ST52, the eighth map generating function F18 generates an elastic modulus map expressing, with pixel values, the elastic modulus with respect to each of the components of the tissue in the living body.

The processing circuitry 60 of the information processing apparatus 600 according to the second embodiment and the modification example of the second embodiment is different from the processing circuitry 40 of the MRI apparatus 1 according to the second embodiment and the modification example of the second embodiment for not having the setting function F1. Because the other various types of functions are substantially equivalent, duplicate descriptions thereof will be omitted. Further, the second embodiment and the modification example of the second embodiment have the same advantageous effects as those of the first embodiment.

By using the magnetic resonance imaging apparatus and the information processing apparatus according to at least one of the embodiments described above, it is possible to simultaneously acquire and systematically evaluate the information about the free water and the information about the bound water inside a living body.

In the above embodiments, the term "processor" means, for example, circuitry such as a dedicated or general-purpose central processing unit (CPU), a graphics processing unit (GPU), an application specific integrated circuit (ASIC), or a programmable logic device (for example, a simple programmable logic device (SPLD), a complex programmable logic device (CPLD), or a field programmable gate array (FPGA)).

When the processor is, for example, a CPU, the processor reads and executes a program stored in storage circuitry to implement various functions. When the processor is, for example, an ASIC, a function corresponding to the program is directly incorporated as logic circuitry in circuitry of the processor instead of the processor storing the program in the storage circuit. In this case, the processor implements various functions by hardware processing of reading and executing the program incorporated in the circuitry, or the processor can also implement various functions by combining software processing and hardware processing.

In the embodiments described above, the example is described in which the single processor of the processing circuitry implements the functions. However, the processing circuitry may be configured by combining a plurality of independent processors, and the processors may implement the respective functions. In a case where the plurality of processors is provided, the storage circuitry that stores the programs may be provided individually for each processor, or one piece of storage circuitry may collectively store the programs corresponding to the functions of all the processors.

The setting function F1 in the description of the embodiments is an example of the setting unit. The obtaining function F2 in the description of the embodiments is an example of the obtainment unit. The classifying function F3 in the description of the embodiments is an example of the classification unit. The OSR calculating function F4, the OSR component calculating function F6, and the component ratio gradient calculating function F8 in the description of the embodiments are examples of the OSR analysis unit. The T2* analyzing function F12 in the description of the embodiments is an example of the T2* analysis unit. The T2* estimating function F14 in the description of the embodiments is an example of the T2* estimation unit. The combining function F16 and the elastic modulus estimating function F10 in the description of the embodiments are examples of the elastic modulus estimation unit. The analysis unit is an example of the OSR analysis unit and the T2* analysis unit. The first to the eighth map generating functions F5, F7, F9, F11, F13, F15, F17, and F18 in the description of the embodiments are examples of the map generation unit.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims are intended to cover such forms or modifications as would fall within the scope and spirit of the inventions.

**Claims**

1.   A magnetic resonance imaging apparatus comprising:

a setting unit configured to set a pulse sequence including a plurality of sub pulse sequences to acquire a plurality of Magnetic Resonance (MR) data each corresponding to a different one of a plurality of echo signals emitted from an object after applying a Magnetization Transfer (MT) pulse and a Radio Frequency (RF) pulse to the object, each of the plurality of sub pulse sequences corresponding to an Ultrashort Echo Time (UTE) sequence, and a scanner configured to acquire the plurality of MR data based on the pulse sequence set by the setting unit, wherein the MR data corresponding to an initial echo signal after the application of the RF pulse to the object among the plurality of echo signals in at least one of the plurality of sub pulse sequences is used for analyzing both bound water and free water in the object.

2.   The magnetic resonance imaging apparatus according to claim 1, wherein an off-resonance frequency of the MT pulse in a first sub pulse sequence included in the plurality of sub pulse sequences is different from an off-resonance frequency of the MT pulse in a second sub pulse sequence included in the plurality of sub pulse sequences.

3.   The magnetic resonance imaging apparatus according to claim 1 or 2,

wherein the setting unit is configured to set the pulse sequence so as to satisfy at least one of: an echo time (TE) corresponding to the initial echo signal after the application of the RF pulse to the object among the plurality of echo signals in a first sub pulse sequence included in the plurality of sub pulse sequences is same as a TE corresponding to an initial echo signal after the application of the RF pulse to the object among the plurality of echo signals in a second sub pulse sequence included in the plurality of sub pulse sequences; or a TE corresponding to second and later echo signals after the application of the RF pulse to the object among the plurality of echo signals in the first sub pulse sequence is different from a TE corresponding to second and later echo signals after the application of the RF pulse to the object among the plurality of echo signals in the second sub pulse sequence.

4. The magnetic resonance imaging apparatus according to any one of claim 1 to 3,
wherein the setting unit is configured to set the pulse sequence in such a manner that the lower the off-resonance frequency is, the larger an echo space is, the echo space being an acquisition interval of each of the plurality of echo signals.

5. The magnetic resonance imaging apparatus according to any one of claims 1 to 4,

wherein the scanner is configured to acquire the plurality of MR data with respect to the object's in vivo tissue that includes the free water and the bound water as components, and
the in vivo tissue is one of: a deep radial cartilage, a calcified cartilage, a meniscus, a ligament, a tendon, a cortical bone, a lung, a cranial nervous system, a central nervous system, and a peripheral nervous system.

6. An information processing apparatus comprising:

an obtainment unit configured to obtain plurality of MR data each corresponding to a different one of a plurality of echo signals emitted from an object after applying an MT pulse and an RF pulse to the object, the plurality of MR data being acquired by a pulse sequence including a plurality of sub pulse sequences each corresponding to a UTE sequence, and
an analysis unit configured to analyze both bound water and free water in the object, based on MR data corresponding to an initial echo signal after the application of the RF pulse to the object among the plurality of echo signals in at least one of the plurality of sub pulse sequences.

7. The information processing apparatus according to claim 6,

wherein an off-resonance frequency of the MT pulse in a first sub pulse sequence included in the plurality of sub pulse sequences is different from an off-resonance frequency of the MT pulse in a second sub pulse sequence included in the plurality of sub pulse sequences, and
the information processing apparatus further comprises:

a classification unit configured to classify the plurality of MR data into a plurality of first MR data each corresponding to a different one of off-resonance frequencies and a plurality of second MR data corresponding to a different one of TEs; and
an elastic modulus estimation unit configured to estimate an elastic modulus with respect to each of components of the object's in vivo tissue, based on at least one of the plurality of first MR data and the plurality of second MR data.

8. The information processing apparatus according to claim 6,

wherein an off-resonance frequency of the MT pulse in a first sub pulse sequence included in the plurality of sub pulse sequences is different from an off-resonance frequency of the MT pulse in a second sub pulse sequence included in the plurality of sub pulse sequences, and
the information processing apparatus further comprises:

a classification unit configured to classify the plurality of MR data into a plurality of first MR data each corresponding to a different one of off-resonance frequencies and a plurality of second MR data each corresponding to a different one of TEs;
a T2* estimation unit configured to estimate a first T2* value based on the plurality of first MR data;
a T2* analysis unit configured to estimate a second T2* value based on the plurality of second MR data; and
an elastic modulus estimation unit configured to estimate an elastic modulus with respect to each of components of the object's in vivo tissue, based on the first T2* value and the second T2* value.

9. The information processing apparatus according to claim 7 or 8, further comprising:
a map generation unit configured to generate an elastic modulus map expressing, with pixel values, the elastic modulus with respect to each of the components of the in vivo tissue.

10. The information processing apparatus according to any one of claims 7 to 9, further comprising:
an OSR analysis unit configured to calculate an Off-resonance Saturation Ratio (OSR) with respect to each of the off-resonance frequencies based on the plurality of first MR data, calculate a dominant off-resonance frequency with respect to each of components of the in vivo tissue based on the OSR of each of the off-resonance frequencies, and calculate a component ratio gradient based on the dominant off-resonance frequency with respect to each of the components of the in vivo tissue.

11. The information processing apparatus according to claim 10, further comprising:

an elastic modulus estimation unit configured to estimate an elastic modulus with respect to each of the components of the in vivo tissue, based on the component ratio gradient,
wherein the components of the in vivo tissue include a component related to loosely bound water and a component related to tightly bound water.

12. The information processing apparatus according to claim 10 or 11,
wherein, the OSR analysis unit is configured to calculate the component ratio gradient being a slope of a component ratio with respect to the off-resonance frequencies, based on the dominant off-resonance frequency with respect to each of the components of the tissue.

13. The information processing apparatus according to any one of claims 10 to 12, further comprising:
a map generation unit configured to generate at least one map selected from among: an OSR map expressing, with pixel values, the OSR with respect to each of the off-resonance frequencies; an OSR component map expressing, with pixel values, the dominant off-resonance frequency with respect to each of the components of the tissue; a component ratio gradient map expressing, with pixel values, the component ratio gradient with respect to each of the components of the tissue; and an elastic modulus map expressing, with pixel values, the elastic modulus with respect to each of the components of the tissue.

14. The information processing apparatus according to any one of claims 6 to 12, further comprising:

a T2* analysis unit configured to estimate a T2* value based on the second MR data; and
a map generation unit configured to generate a T2* map expressing the T2* value with a pixel value.

15. The information processing apparatus according to any one of claims 6 to 12, further comprising:

a T2* estimation unit configured to estimate a first T2* value based on the plurality of first MR data;
a T2* analysis unit configured to estimate a second T2* value based on the plurality of second MR data; and
a map generation unit configured to generate a T2* map expressing T2* values with pixel values, based on the first T2* value and the second T2* value.

FIG. 1

LOOSELY BOUND WATER TO MINERAL

LOOSELY BOUND WATER TO COLLAGEN

CARBONATED APATITE STRUCTURE

CARBONATED APATITE STRUCTURE

STRUCTURE WATER

TIGHTLY BOUND WATER

COLLAGEN FIBER

MINERALIZED FIBER

MINERAL CRYSTAL

FREE WATER (PORE WATER)

LACUNAR CANALICULAR NETWORK

CENTRAL CANAL

CORTICAL BONE

FIG. 2

COLLAGEN BOUND WATER
TO COLLAGEN

REGION WHERE BOUND WATER
IS DOMINANT

PORE WATER AND FAT

REGION WHERE FREE WATER
IS DOMINANT

OBJECT P1
OBJECT P2

## FIG. 3

REGION WHERE BOUND WATER IS DOMINANT

REGION WHERE FREE WATER IS DOMINANT

TIGHT

BINDING FORCE

LOOSE

TBW

LBW

T2* Short

T2* Long

SHORT                    T2* VALUE                    LONG

## FIG. 4

FIG. 5

START

SET PULSE SEQUENCE ~ST11

PERFORM SCAN ~ST12

OBTAIN MR DATA ~ST13

CLASSIFY MR DATA INTO
FIRST MR DATA AND SECOND MR DATA ~ST14

GENERATE MAP BASED ON FIRST MR DATA ~ST20

GENERATE MAP BASED ON SECOND MR DATA ~ST30

END

# FIG. 6

FIG. 7

EP 4 787 005 A2

FIG. 8

FIRST SUB PULSE SEQUENCE

RF

GRADIENT MAGNETIC FIELD (ALL AXES)

DATA ACQUISITION

MT PULSE

SECTION1

RF EXCITATION PULSE

SPOILER

TE1  TE2  TE3  TE4

SECTION2

SECOND SUB PULSE SEQUENCE

RF

GRADIENT MAGNETIC FIELD (ALL AXES)

DATA ACQUISITION

MT PULSE

RF EXCITATION PULSE

SPOILER

TE1  TE2  TE3  TE4

THIRD SUB PULSE SEQUENCE

RF

GRADIENT MAGNETIC FIELD (ALL AXES)

DATA ACQUISITION

MT PULSE

RF EXCITATION PULSE

SPOILER

TE1  TE2  TE3  TE4

EP 4 787 005 A2

EP 4 787 005 A2

| | PARAMETERS OF MT PULSE | | | PARAMETERS OF PLURALITY OF TES | | |
|---|---|---|---|---|---|---|
| | NUMBER OF PULSE | FLIP ANGLE | OFF-RESONANCE FREQUENCY | FIRST TE | ECHO SPACE | QUANTITY OF MULTIPLE ECHOES |
| FIRST SUB PULSE SEQUENCE | 1 | 300 | 500 | 0.1 | 2.2 | 4 |
| SECOND SUB PULSE SEQUENCE | 1 | 300 | 1500 | 0.1 | 3.0 | 4 |
| THIRD SUB PULSE SEQUENCE | 1 | 300 | 10000 | 0.1 | 3.8 | 4 |
| FORTH SUB PULSE SEQUENCE | - | - | - | - | - | - |
| FIFTH SUB PULSE SEQUENCE | - | - | - | - | - | - |

## FIG. 9A

| | PARAMETERS OF MT PULSE | | | PARAMETERS OF PLURALITY OF TES | | |
|---|---|---|---|---|---|---|
| | NUMBER OF PULSE | FLIP ANGLE | OFF-RESONANCE FREQUENCY | FIRST TE | ECHO SPACE | QUANTITY OF MULTIPLE ECHOES |
| FIRST SUB PULSE SEQUENCE | 1 | 300 | 500 | 0.1 | 2.2 | 4 |
| SECOND SUB PULSE SEQUENCE | 1 | 300 | 1500 | 0.1 | 2.8 | 4 |
| THIRD SUB PULSE SEQUENCE | 1 | 300 | 3000 | 0.1 | 3.4 | 4 |
| FORTH SUB PULSE SEQUENCE | 1 | 300 | 10000 | 0.1 | 4.0 | 4 |
| FIFTH SUB PULSE SEQUENCE | - | - | - | - | - | - |

## FIG. 9B

FIG. 10

START (ST20)

| OBTAIN FIRST MR DATA | ST201 |

| CALCULATE OSR | ST202 |

| GENERATE OSR MAP | ST203 |

| CALCULATE DOMINANT OFF-RESONANCE FREQUENCY WITH RESPECT TO EACH OF COMPONENTS | ST204 |

| GENERATE OSR-LBW MAP AND OSR-TBW MAP | ST205 |

| CALCULATE COMPONENT RATIO GRADIENT | ST206 |

| GENERATE COMPONENT RATIO GRADIENT MAP | ST207 |

| ESTIMATE ELASTIC MODULUS | ST208 |

| GENERATE ELASTIC MODULUS MAP | ST209 |

END (ST20)

# FIG. 11

FIG. 12A

FIG. 12B

FIG. 12C

OSR (%)

OFF-RESONANCE FREQUENCY (Hz)

# FIG. 13A

OFF-RESONANCE FREQUENCY (Hz)

# FIG. 13B

FIG. 14A

FIG. 14B

FIG. 14C

FIG. 15

FIG. 16A

FIG. 16B

START (ST30)

OBTAIN SECOND MR DATA —— ST301

ESTIMATE T2* VALUES —— ST302

GENERATE T2* MAP —— ST303

END (ST30)

# FIG. 17

■ FIRST SUB PULSE SEQUENCE
▨ SECOND SUB PULSE SEQUENCE
□ THIRD SUB PULSE SEQUENCE

SIGNAL INTENSITY

TE1

TE2

TE3

TE4

0          5          10          15

TE(ms)

# FIG. 18

FIG. 19

FIG. 20

EP 4 787 005 A2

START

| SET PULSE SEQUENCE | ST11 |

| PERFORM SCAN | ST12 |

| OBTAIN MR DATA | ST13 |

| CLASSIFY MR DATA INTO<br>FIRST MR DATA AND SECOND MR DATA | ST14 |

| GENERATE MAP BASED ON FIRST MR DATA | ST20 |

| GENERATE MAP BASED ON SECOND MR DATA | ST30 |

| ESTIMATE T2* VALUES BASED ON FIRST MR DATA | ST41 |

| COMBINE T2* VALUES | ST42 |

| GENERATE COMBINE T2* MAP | ST43 |

END

# FIG. 21

**FIG. 22**

40

- F1 SETTING FUNCTION
- MR DATA
- F2 OBTAINING FUNCTION
- F3 CLASSIFYING FUNCTION
- FIRST MR DATA (MR IMAGE OF FIRST ECHO)
- SECOND MR DATA (MR IMAGE OF MULTIPLE ECHO)

Region where bound water is dominant:
- F14 $T2^*$ ESTIMATING FUNCTION → F15 SIXTH MAP GENERATING FUNCTION → $T2^*$ MAP
- F4 OSR CALCULATING FUNCTION → F5 FIRST MAP GENERATING FUNCTION → OSR MAP
- F6 OSR COMPONENT CALCULATING FUNCTION → F7 SECOND MAP GENERATING FUNCTION → OSR—LBW MAP, OSR—TBW MAP
- F8 COMPONENT RATIO GRADIENT CALCULATING FUNCTION → F9 THIRD MAP GENERATING FUNCTION → COMPONENT RATIO GRADIENT MAP

REGION WHERE BOUND WATER IS DOMINANT

REGION WHERE FREE WATER IS DOMINANT
- F12 $T2^*$ ANALYZING FUNCTION → F13 FIFTH MAP GENERATING FUNCTION → $T2^*$ MAP

- F16 COMBINING FUNCTION
- F17 SEVENTH MAP GENERATING FUNCTION → COMBINED $T2^*$ MAP
- F10 ELASTIC MODULUS ESTIMATING FUNCTION → F18 EIGHTH MAP GENERATING FUNCTION → LASTIC MODULUS MAP

START

SET PULSE SEQUENCE — ST11

PERFORM SCAN — ST12

OBTAIN MR DATA — ST13

CLASSIFY MR DATA INTO
FIRST MR DATA AND SECOND MR DATA — ST14

GENERATE MAP BASED ON FIRST MR DATA — ST20

GENERATE MAP BASED ON SECOND MR DATA — ST30

ESTIMATE T2* VALUES BASED ON FIRST MR DATA — ST41

COMBINE T2* VALUES — ST42

ESTIMATE ELASTIC MODULUS BASED ON
COMBINE T2* VALUES — ST51

GENERATE ELASTIC MODULUS MAP — ST52

END

# FIG. 23